# EUROPÄISCHE PATENTSCHRIFT

(11) **EP 1 745 113 B1**
(45) Veröffentlichungstag und Bekanntmachung des Hinweises auf die Patenterteilung: **26.10.2016**
(21) Anmeldenummer: 05759201.6
(22) Anmeldetag: 10.05.2005
(51) Int. Cl.: C09K 11/06, C07F 5/00, C09B 23/14, C09B 57/00, H01L 51/00, H01L 51/50, H05B 33/14

(54) **NEUE MATERIALMISCHUNGEN FÜR DIE ELEKTROLUMINESZENZ**
NOVEL MATERIAL MIXTURES FOR USE IN ELECTROLUMINESCENCE
NOUVEAUX MELANGES DE MATERIAUX POUR APPLICATIONS ELECTROLUMINESCENTES

(30) Priorität: 11.05.2004 DE 102004023277
(43) Veröffentlichungstag der Anmeldung: 24.01.2007
(73) Patentinhaber: Merck Patent GmbH, 64293 Darmstadt (DE)
(72) Erfinder: BÜSING, Arne, 65929 Frankfurt (DE); SCHEURICH, René, 64846 Gross-Zimmern (DE); HEUN, Susanne, 65812 Bad Soden (DE); BACH, Ingrid, 65719 Hofheim (DE)
(86) Internationale Anmeldenummer: PCT/EP2005/005021
(87) Internationale Veröffentlichungsnummer: WO 2005/111172

(56) Entgegenhaltungen:
- WO-A-03/092334
- WO-A-2004/015025
- WO-A1-2005/040302
- DE-A1- 10 238 903
- WONG W-Y ET AL: "Triplet emission in platinum-containing Poly(alkynylsilanes)" MACROMOLECULES, ACS, WASHINGTON, DC, US, Bd. 36, 2003, Seiten 983-990, XP002337028 ISSN: 0024-9297

## Beschreibung

Seit ca. 13 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in WO 90/13148 offenbart sind. Seit kurzem ist auch ein erstes Produkt in Form einer kleineren Anzeige (in einem Rasierapparat der Fa. PHILIPS N.V.) am Markt erhältlich. Allerdings sind immer noch deutliche Verbesserungen nötig, um diese Displays zu einer echten Konkurrenz zu den derzeit marktbeherrschenden Flüssigkristallanzeigen zu machen.

Eine Entwicklung, die sich seit einigen Jahren vor allem auf dem Gebiet der "Small molecule"-Displays abzeichnet, ist der Einsatz von Materialien, die aus dem Triplett-Zustand Licht emittieren können und somit Phosphoreszenz statt Fluoreszenz zeigen (M. A. Baldo et al., Appl. Phys. Lett. 1999, 75, 4-6), wodurch eine bis zu vierfache Energie- und Leistungseffizienz möglich ist. Als wesentliche Bedingungen für die praktische Anwendbarkeit sind hier insbesondere ein effizienter Energieübertrag von der Matrix auf den Triplett-Emitter (und damit verbunden effiziente Lichtemission), eine hohe operative Lebensdauer und eine niedrige Betriebsspannung zu nennen. WO03/092334 und DE10238903 offenbaren Polymere beinhaltend einem Triplett -Emitter mit einer Struktureinheit die Si-Einheiten beinhaltet.

In letzter Zeit gibt es zunehmend Bemühungen, sich die Vorteile aufdampfbarer Triplett-Emitter auch für Polymeranwendungen zu Nutze zu machen. So werden so genannte Hybrid-Device-Strukturen erwogen, die die Vorteile der "Small-molecule"-OLEDs mit denen der Polymer-OLEDs (= PLEDs) verbinden und durch Mischen des Triplett-Emitters in das Polymer entstehen. Dies hat den Vorteil, dass die Verbindungen aus Lösung verarbeitet werden können und dass kein teurer und aufwändiger Aufdampfprozess wie für Devices auf Basis niedermolekularer Verbindungen erforderlich ist. Das Aufbringen aus Lösung (z. B. durch hochauflösende Druckverfahren) wird langfristig deutliche Vorteile gegenüber dem heute gängigen Vakuum-Verdampfungsprozess aufweisen, v. a. hinsichtlich Skalierbarkeit, Strukturierbarkeit, Beschichtungseffizienz und Ökonomie. Auch hier ist ein geeignetes Matrixmaterial notwendig, das einen effizienten Energietransfer auf den Triplett-Emitter ermöglicht und das in Verbindung mit diesem gute Lebensdauern bei niedrigen Betriebsspannungen aufweist. Trotz der in letzter Zeit auf diesem Gebiet erzielten Fortschritte gibt es immer noch erhebliches Verbessungspotenzial für entsprechende Materialien auf dem Gebiet der löslichen Triplett-Emitter. U. a. auf folgenden Feldern ist weiterhin ein deutlicher Verbesserungsbedarf zu sehen:
(1) Die Effizienz der Elektrolumineszenzelemente muss noch weiter verbessert werden. Dass prinzipiell eine höhere Effizienz möglich ist, zeigen die Ergebnisse von Elektrolumineszenzelementen auf Basis kleiner Moleküle.
(2) Die Spannung der Elektrolumineszenzelemente ist noch zu hoch für hochwertige elektronische Anwendungen.
(3) Matrixmaterialien, die mit einem Triplett-Emitter gute Ergebnisse zeigen, zeigen häufig mit anderen Emittern, selbst bei vergleichbarer Emissionsfarbe, deutlich schlechtere Ergebnisse. Es wäre wünschenswert, ein universelles Matrixmaterial zur Verfügung zu haben, das für eine Vielzahl verwendeter Triplett-Emitter und möglichst auch für mehrere oder alle Emissionsfarben gute Ergebnisse liefert.

Es ist also offensichtlich, dass auf dem Gebiet der löslichen Triplett-Emitter und entsprechender geeigneter Matrixmaterialien weiterhin ein großer Verbesserungsbedarf besteht.

Überraschend wurde gefunden, dass - bisher unbekannte - Polymer-Mischungen, die bestimmte Struktureinheiten enthalten, in Kombination mit Triplett-Emittern hier deutliche Verbesserungen im Vergleich zu Mischungen gemäß dem Stand der Technik ergeben. Insbesondere sind diese Materialien geeignet, mit einer großen Breite unterschiedlicher rot und grün emittierender Triplettemitter effiziente Emission zu zeigen. Diese Mischungen sind daher Gegenstand der vorliegenden Anmeldung.

Gegenstand der Erfindung sind Mischungen (Blends), enthaltend
(A) mindestens ein Polymer,
(B) mindestens eine Struktureinheit, die mindestens ein Element der 4. Hauptgruppe (Gruppe 14 gemäß IUPAC) ungleich Kohlenstoff enthält, also Silicium, Germanium, Zinn und/oder Blei,
   und
(C) mindestens einen Triplett-Emitter.

### Die erfindungsgemäßen Mischungen liegen vorzugsweise als amorphe Mischungen vor.

Unter einem Triplett-Emitter im Sinne der Erfindung soll eine Verbindung verstanden werden, die aus dem Triplett-Zustand Licht emittiert, also in der Elektrolumineszenz Phosphoreszenz statt Fluoreszenz zeigt, bevorzugt ein metallorganischer Triplett-Emitter.

Die Struktureinheiten, die mindestens ein Element der 4. Hauptgruppe ungleich Kohlenstoff enthalten, enthalten direkte Silicium-Silicium- oder Germanium-Germanium-Bindungen, und/oder sie enthalten mindestens eine Teilstruktur gemäß Formel (1):

A-Y Formel (1),

wobei für die Symbole gilt:
- A: ist bei jedem Auftreten gleich oder verschieden Si, Ge, Sn oder Pb;
- Y: ist bei jedem Auftreten gleich oder verschieden ein aromatisches oder heteroaromatisches Ringsystem mit 2 bis 40 C-Atomen, das durch einen oder mehrere Reste R⁴ substituiert sein kann, eine Vinylgruppe -CR⁴=CR⁴- bzw. -CR⁴=C(R⁴)₂, eine Acetylengruppe -C≡C- bzw. -C≡CR⁴ oder eine Kombination aus 2 bis 5 dieser Gruppen, wie beispielsweise eine Stilbengruppe oder eine Tolangruppe; dabei steht Y für eine monovalente oder eine bivalente Gruppe;
- R⁴: ist bei jedem Auftreten gleich oder verschieden H, F, Cl, Br, I, CN, OH, NO₂, eine geradkettige, verzweigte oder cyclische Alkyl-, Alkoxy- oder Thioalkoxygruppe mit 1 bis 22 C-Atomen, in der auch ein oder mehrere nicht benachbarte C-Atome durch -R⁵C=CR⁵-, -C≡C-, Si(R⁵)₂, Ge(R⁵)₂, Sn(R⁵)₂, -NR⁵-, -O-, -S-, -CO-O-, -O-CO-O- ersetzt sein können, wobei auch ein oder mehrere H-Atome durch F, Cl, Br, I, CN oder NO₂ ersetzt sein können, eine Aryl-, Heteroaryl- oder Aryloxygruppe mit 1 bis 40 C-Atomen, welche auch durch ein oder mehrere Reste R⁵ substituiert sein können, oder OH, N(R⁵)₂, B(R⁵)₂ oder Si(R⁵)₃;
- R⁵: ist bei jedem Auftreten gleich oder verschieden H oder ein aliphatischer oder aromatischer Kohlenwasserstoffrest mit 1 bis 20 C-Atomen.

Die Struktureinheiten, die mindestens ein Element der 4. Hauptguppe ungleich Kohlenstoff enthalten, enthalten mindestens eine Struktureinheit gemäß den Formeln (2) bis (5), 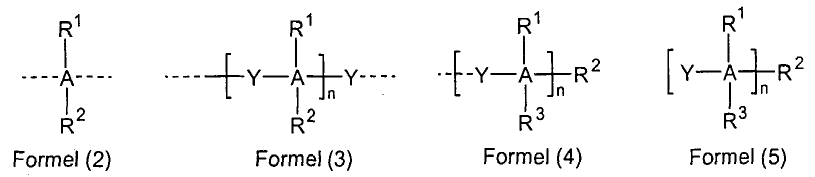 wobei die Symbole A, Y, R⁴ und R⁵ dieselbe Bedeutung haben, wie unter Formel (1) beschrieben; dabei steht Y in den Formeln (3) und (4) für bivalente Gruppen und in Formel (5) für eine monovalente Gruppe; die weiteren Symbole haben die folgende Bedeutung:
- R¹, R², R³: ist bei jedem Auftreten gleich oder verschieden H, F, CN, N(R⁴)₂, eine geradkettige, verzweigte oder cyclische Alkyl-, Alkoxy- oder Thioalkoxygruppe mit 1 bis 40 C-Atomen, die mit R⁴ substituiert sein kann, wobei ein oder mehrere nicht benachbarte CH₂-Gruppen durch -R⁵C=CR⁵-, -C≡C-, Si(R⁵)₂, Ge(R⁵)₂, Sn(R⁵)₂, C=O, C=S, C=Se, C=NR⁵, -O-, -S-, -NR⁵- oder -CONR⁵- ersetzt sein können und wobei ein oder mehrere H-Atome durch F, Cl, Br, I, CN, OH oder NO₂ ersetzt sein können, oder ein aromatisches bzw. heteroaromatisches Ringsystem oder eine Aryloxy- oder Heteroaryloxygruppe jeweils mit 2 bis 40 aromatischen C-Atomen, wobei ein oder mehrere H-Atome durch F, Cl, Br, I, CN, OH oder NO₂ ersetzt sein können oder die durch einen oder mehrere Reste R⁴ substituiert sein kann, oder eine Kombination aus 2 bis 5 dieser Systeme, wie beispielsweise eine Stilbengruppe, eine Alkylarylgruppe oder eine Tolangruppe; dabei können zwei oder mehrere Substituenten R¹, R² und/oder R³ miteinander ein weiteres möno- oder polycyclisches, aliphatisches oder aromatisches Ringsystem aufspannen;
- n: ist bei jedem Auftreten gleich oder verschieden 1, 2, 3 oder 4;

die gestrichelte Bindung stellt die Anknüpfung an das Polymer dar; sie soll hier keine Methylgruppe bedeuten.

Dabei können Polymere, die Einheiten gemäß Formel (2) enthalten, direkte Bindungen zwischen zwei oder mehreren Elementen A aufweisen.

Ein geeignetes Verhältnis der einzelnen Komponenten ist beispielsweise eine Mischung, die insgesamt 1 - 99.5 mol%, bevorzugt 5 - 80 mol%, besonders bevorzugt 10 - 50 mol% Einheiten gemäß Formel (1), bzw. gemäß Formeln (2) bis (5) enthält und 0.1 - 95 mol%, bevorzugt 0.5 - 80 mol%, besonders bevorzugt 1-50 mol%, insbesondere 2 - 25 mol% eines oder mehrerer Triplett-Emitter enthält, wobei sich die Angaben auf die gesamt vorhandenen Einheiten (Blendbestandteile bzw. Wiederholeinheiten im Polymer) beziehen. Dies ist unabhängig davon, ob die Komponenten kovalent an ein Polymer gebunden oder eingemischt sind.

Dabei hat sich gezeigt, dass insbesondere ein Anteil von 10 - 50 mol% Einheiten gemäß Formel (1), bzw. gemäß Formeln (2) bis (5) zu hoher Lichtemission aus dem Triplett-Emitter führen.

Bei den erfindungsgemäßen Mischungen gibt es verschiedene Ausführungsformen, bei denen die Einheiten gemäß Formel (1) und/oder der Triplett-Emitter entweder eingemischt oder kovalent an das Polymer gebunden sind. Dabei sind Einheiten gemäß den Formeln (2) bis (4) kovalent an das Polymer gebunden. Formel (5) zeigt eingemischte Einheiten. Bei kovalenter Bindung an das Polymer kann das Element A (also das Element der 4. Hauptgruppe ungleich Kohlenstoff) entweder in die Hauptkette (Formeln 2 und 3) oder in die Seitenkette (Formel 4) des Polymers gebunden werden.

Unter einem aromatischen bzw. heteroaromatischen Ringsystem im Sinne dieser Erfindung soll ein System verstanden werden, das nicht notwendigerweise nur aromatische bzw. heteroaromatische Gruppen enthält, sondern in dem auch mehrere aromatische bzw. heteroaromatische Gruppen durch eine kurze nichtaromatische Einheit (weniger als 10 % der von H verschiedenen Atome, bevorzugt weniger als 5 % der von H verschiedenen Atome), wie beispielsweise sp³-hybridisierter C, O, N, etc., unterbrochen sein können. So sollen also beispielsweise auch Systeme wie 9,9'-Spirobifluoren, 9,9-Diarylfluoren, Triarylamin, Diarylether, etc. als aromatische Systeme verstanden werden. Dabei enthält ein aromatisches Ringsystem mindestens 6 C-Atome, während ein heteroaromatisches Ringsystem mindestens 2 C-Atome und mindestens ein Heteroatom, bevorzugt ausgewählt aus N, O und/oder S, enthält und die Summe aus C-Atomen und Heteroatomen mindestens 5 beträgt.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden besonders bevorzugt Methoxy, Ethoxy, n-Propoxy, i-Propoxy, n-Butoxy, i-Butoxy, s-Butoxy, t-Butoxy oder 2-Methylbutoxy verstanden. Unter einer C₂-C₄₀ Aryl- oder Heteroarylgruppe, die je nach Verwendung monovalent oder bivalent sein kann, die noch jeweils mit den oben genannten Resten R¹ substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Chrysen, Perylen, Fluoranthen, Tetracen, Pentacen, Benzpyren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol. Unter aromatischen Ringsystemen werden weiterhin insbesondere Biphenylen, Terphenylen, Fluoren, Spirobifluoren, Dihydrophenanthren, Dihydropyren, Tetrahydropyren oder cis- oder trans-Indenofluoren verstanden.

Eine Ausführungsform der Erfindung sind Mischungen BLEND1, enthaltend
(A) 5 - 99.9 Gew.% mindestens eines Polymers POLY1, enthaltend 1-100 mol%, bevorzugt 5 - 80 mol%, besonders bevorzugt 10 - 50 mol% einer oder mehrerer Wiederholeinheiten gemäß Formel (1), bzw. gemäß Formeln (2) bis (4),
   und außerdem
(B) 0.1 - 95 Gew.%, bevorzugt 0.5 - 80 Gew.%, besonders bevorzugt 1 - 50 Gew.%, insbesondere 2-25 Gew.% eines oder mehrerer Triplett-Emitter (TRIP1).

In der Ausführungsform BLEND1 ist der Triplett-Emitter (TRIP1) zu dem Polymer POLY1 gemischt. Die Wiederholeinheiten gemäß Formel (1), bzw. gemäß Formeln (2) bis (4) sind kovalent an das Polymer gebunden. Je nach Verknüpfung sind diese Struktureinheiten in die Hauptkette des Polymers (Formeln 2 und 3) oder in die Seitenkette (Formel 4) des Polymers eingebaut.

Eine weitere Ausführungsform dieser Erfindung sind Mischungen BLEND2, enthaltend
(A) 0.5-99 Gew.% mindestens eines Polymers POLY2, enthaltend 0.1-100 mol% eines oder mehrerer Triplett-Emitter (TRIP2) kovalent gebunden, und außerdem
(B) 1-99.5 Gew.% mindestens einer Verbindung gemäß Formel (1), bzw. gemäß Formel (5), die in der Lage ist, bei Raumtemperatur glasartige Schichten zu bilden, bevorzugt mit einer Glasübergangstemperatur größer 80 °C, besonders bevorzugt größer 100 °C.

Der Triplett-Emitter TRIP2 kann dabei in die Haupt- und/oder in die Seitenkette des Polymers POLY2 eingebaut werden.

Eine weitere Ausführungsform dieser Erfindung sind Mischungen BLEND3, enthaltend
(A) 0.5-98.5 Gew.% mindestens eines Polymers POLY3;
(B) 1-99 Gew.% mindestens einer Verbindung gemäß Formel (1), bzw. gemäß Formel (5), die in der Lage ist, bei Raumtemperatur glasartige Schichten zu bilden, bevorzugt mit einer Glasübergangstemperatur größer 80 °C, besonders bevorzugt größer 100 °C;
   und außerdem
(C) 0.1-95 Gew.%, bevorzugt 0.5 80 Gew.%, besonders bevorzugt 1 - 50 Gew.%, insbesondere 2 - 25 Gew.% eines oder mehrerer Triplett-Emitter (TRIP1).

Die Polymere POLY1 bis POLY3 können konjugiert, teilkonjugiert oder nichtkonjugiert sein. Bevorzugt sind sie konjugiert oder teilkonjugiert.

Konjugierte Polymere im Sinne dieser Erfindung sind Polymere, die in der Hauptkette hauptsächlich sp²-hybridisierte (bzw. auch sp-hybridisierte) Kohlenstoffatome enthalten, die auch durch entsprechende Heteroatome ersetzt sein können. Dies bedeutet im einfachsten Fall abwechselndes Vorliegen von Doppel- und Einfachbindungen in der Hauptkette. Hauptsächlich meint, dass natürlich (ohne weiteres Zutun) auftretende Defekte, die zu Konjugationsunterbrechungen führen, den Begriff "konjugiertes Polymer" nicht entwerten. Des Weiteren wird in diesem Anmeldetext ebenfalls als konjugiert bezeichnet, wenn sich in der Hauptkette Arylamineinheiten, Arylphosphineinheiten und/oder bestimmte Heterocyclen (d. h. Konjugation über N-, O-, S- oder P-Atome) und/oder metallorganische Komplexe, wie beispielsweise Einheiten gemäß TRIP2 (Konjugation über das Metallatom), befinden. Ebenfalls als konjugiert bezeichnet wird die so genannte σ-Konjugation, also beispielsweise die Konjugation über ein Silicium-Atom. Teilkonjugierte Polymere im Sinne dieser Erfindung sind Polymere, die entweder in der Hauptkette längere konjugierte Abschnitte enthalten, die durch nicht-konjugierte Abschnitte unterbrochen werden, oder die in den Seitenketten eines in der Hauptkette nicht-konjugierten Polymers längere konjugierte Abschnitte enthalten. Hingegen würden Einheiten, wie beispielsweise einfache Alkylenketten, (Thio)Etherbrücken, Ester-, Amid- oder Imidverknüpfungen eindeutig als nicht-konjugierte Segmente definiert.

Die Polymere POLY1, POLY2 und POLY3 können außer den Einheiten gemäß Formeln (1), bzw. gemäß Formeln (2) bis (4) (in POLY1) und dem Triplett-Emitter TRIP2 (in POLY2) verschiedene weitere Strukturelemente enthalten. Diese können beispielsweise Struktureinheiten sein, die das Polymergrundgerüst bilden können, oder Struktureinheiten, die die Ladungsinjektions- bzw. Ladungstransporteigenschaften verbessern. Solche Einheiten sind beispielsweise in WO 03/020790 und in WO 05/014689 ausführlich beschrieben.

Wenn es sich bei den Polymeren POLY1, POLY2 oder POLY3 um nicht-konjugierte Polymere handelt, kommen hierFür prinzipiell beliebige Verbindungsklassen in Frage, sofern die Polymere eine ausreichende Löslichkeit in einem Lösemittel oder Lösemittelgemisch aufweisen, in dem auch die anderen Blendbestandteile löslich sind, so dass alle Komponenten gemeinsam aus Lösung verarbeitet werden können.

Die Polymere POLY1, POLY2 und POLY3 sind entweder Homopolymere, d. h. sie enthalten nur eine einzelne Monomerstruktur, oder es sind Copolymere. Die Copolymere können statistische, alternierende oder auch blockartige Strukturen aufweisen oder auch mehrere dieser Strukturen abwechselnd besitzen. Ebenso können die Polymere linear, verzweigt oder dendritisch aufgebaut sein. Durch das Verwenden mehrerer verschiedener Strukturelemente können Eigenschaften, wie z. B. Löslichkeit, Festphasenmorphologie, etc., eingestellt werden.

Die Polymere POLY1, POLY2 und POLY3 werden durch Polymerisation von einem oder mehreren Monomeren hergestellt. Insbesondere für die Synthese konjugierter Polymere haben sich hier einige Typen bewährt, die zu C-C-Verknüpfungen (SUZUKI-Kupplung, YAMAMOTO-Kupplung, STILLE-Kupplung) oder zu C-N-Verknüpfungen (HARTWIG-BUCHWALD-Kupplung) führen. Wie die Polymerisation nach diesen Methoden durchgeführt werden kann und wie die Polymere vom Reaktionsmedium abgetrennt und aufgereinigt werden können, ist beispielsweise im Detail in WO 04/037887 beschrieben. Eine Methode zur Bildung von Silicium-Aryl-Bindungen ist in US 2003/0120124 beschrieben und besteht in der Reaktion von Aryldiazonium-Salzen mit substituierten Chlorsilanen.

Nach diesen Methoden kann auch die Synthese teilkonjugierter oder nichtkonjugierter Polymere durchgeführt werden, indem entsprechende Monomere verwendet werden, die nicht durchgängig konjugiert sind. Für teilkonjugierte oder nicht-konjugierte Polymere kommen aber auch andere Synthesemethoden in Frage, wie sie allgemein aus der Polymerchemie geläufig sind, wie beispielsweise Polykondensationen oder kationische, anionische oder radikalische Polymerisationen, die beispielsweise über die Reaktion von Alkenen ablaufen und zu Polyethylen-Derivaten im weitesten Sinne führen, wie beispielsweise Polystyrol-Derivate, etc., die die Chromophore gegebenenfalls in den Seitenketten gebunden enthalten. Polysilane können beispielsweise gemäß der Wurtz-Synthese durch Umsetzung entsprechend substituierter Dichlorsilane mit metallischem Natrium erzeugt werden.

In einer bevorzugten Ausführungsform der Erfindung steht das Symbol A bei jedem Auftreten gleich oder verschieden für Si oder Ge, ganz besonders bevorzugt für Si.

Weiterhin bevorzugt steht das Symbol Y gleich oder verschieden bei jedem Auftreten für ein aromatisches Ringsystem mit 2 bis 40 C-Atomen, das durch einen oder mehrere Reste R⁴ substituiert sein kann oder eine durch R⁴ substituierte oder unsubstituierte Stilben- bzw. Tolangruppe, ganz besonders bevorzugt für ein aromatisches Ringsystem mit 2 bis 20 C-Atomen, das durch einen oder mehrere Reste R⁴ substituiert sein kann.

Weiterhin bevorzugt steht mindestens einer der Substituenten R¹ bis R³ für ein aromatisches Ringsystem mit 2 bis 40 C-Atomen, das mit einem oder mehreren Substituenten R⁴ substituiert sein kann; besonders bevorzugt stehen alle Substituenten R¹ bis R³ für aromatische Ringsysteme mit jeweils 2 bis 20 C-Atomen, die mit einem oder mehreren Substituenten R⁴ substituiert sein können.

Weiterhin bevorzugt ist der Index n bei jedem Auftreten gleich oder verschieden 1, 2 oder 3, besonders bevorzugt 1 oder 2.

Weiterhin bevorzugt sind Einheiten gemäß Formel (2) bis (5) symmetrisch aufgebaut. Diese Bevorzugung ist aus der leichteren synthetischen Zugänglichkeit dieser Verbindungen zu begründen. Für Verbindungen gemäß Formel (2) gilt also bevorzugt R¹ = R². Für Verbindungen gemäß Formel (3) gilt bevorzugt, dass alle Y gleich zu wählen sind und dass alle R¹ = R² sind. Für Verbindungen gemäß Formel (4) gilt bevorzugt, dass R¹ = R² = R³ ist. Für Verbindungen gemäß Formel (5) gilt bevorzugt, dass R¹ = R² = R³ und gegebenenfalls = Y ist.

Beispiele für bevorzugte Einheiten gemäß Formeln (2) bis (5) sind substituierte oder unsubstituierte Strukturen gemäß den abgebildeten Beispielen (1) bis (48), wobei die gestrichelten Bindungen eine Verknüpfung im Polymer bedeuten; dabei sind die Beispiele (1) bis (6) Beispiele für die allgemeine Formel (2), die Beispiele (7) bis (21) Beispiele für die allgemeine Formel (3), die Beispiele (22) bis (33) Beispiele für die allgemeine Formel (4), die Beispiele (34) bis (48) Beispiele für die allgemeine Formel (5). Alkyl steht für eine geradkettige, verzweigte oder cyclische Alkylkette, die substituiert oder unsubstituiert sein kann und in der ein oder mehrere H-Atome durch Fluor ersetzt sein können, wie für R¹, R² und R³ definiert. Potenzielle Substituenten sind wegen der besseren Übersichtlichkeit in der Regel nicht abgebildet.

| | | |
|---|---|---|
| 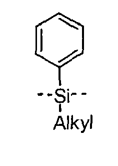 | 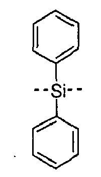 | 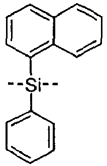 |
| Beispiel 1 | Beispiel 2 | Beispiel 3 |
| 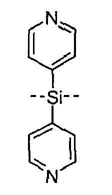 | 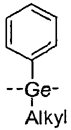 | 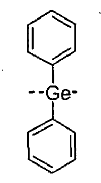 |
| Beispiel 4 | Beispiel 5 | Beispiel 6 |
| 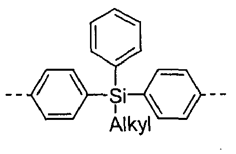 | 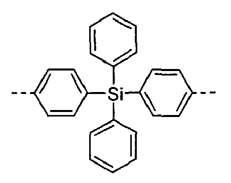 | 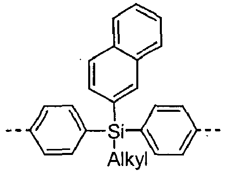 |
| Beispiel 7 | Beispiel 8 | Beispiel 9 |
| 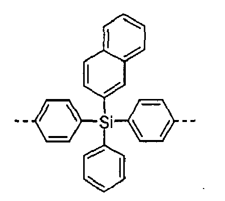 | 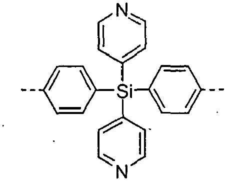 | 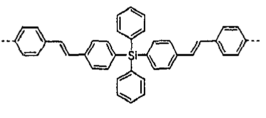 |
| Beispiel 10 | Beispiel 11 | Beispiel 12 |
| 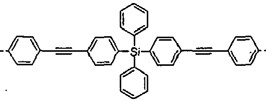 | 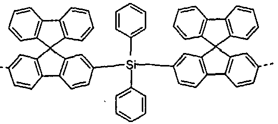 | 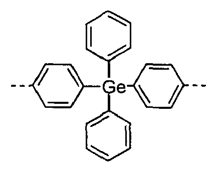 |
| Beispiel 13 | Beispiel 14 | Beispiel 15 |
| 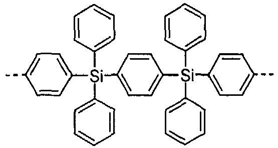 | 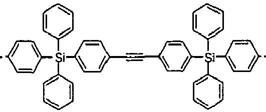 | 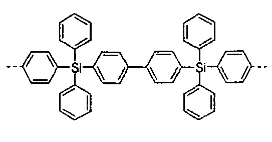 |
| Beispiel 16 | Beispiel 17 | Beispiel 18 |
| 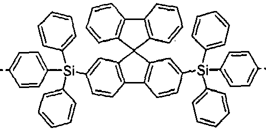 | 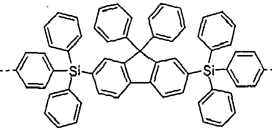 | 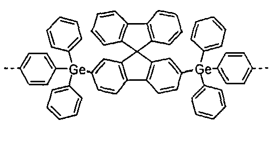 |
| Beispiel 19 | Beispiel 20 | Beispiel 21 |
| 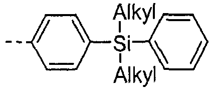 | 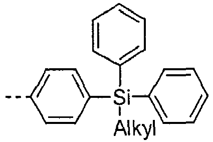 | 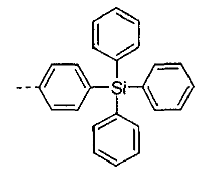 |
| Beispiel 22 | Beispiel 23 | Beispiel 24 |
| 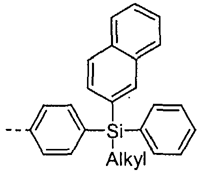 | 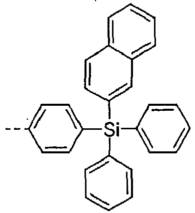 | 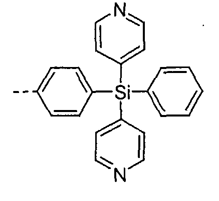 |
| Beispiel 25 | Beispiel 26 | Beispiel 27 |
| 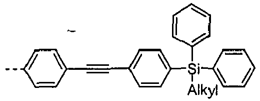 | 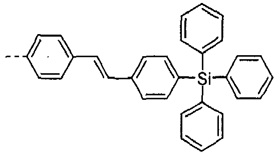 | 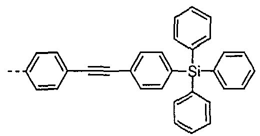 |
| Beispiel 28 | Beispiel 29 | Beispiel 30 |
| 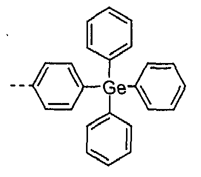 | 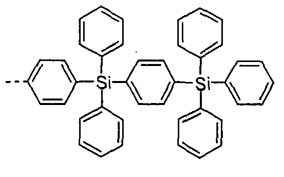 | 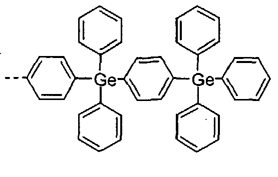 |
| Beispiel 31 | Beispiel 32 | Beispiel 33 |
| 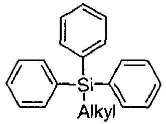 | 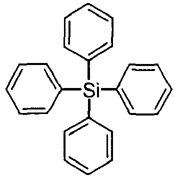 | 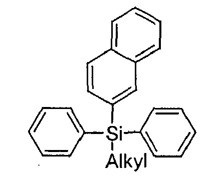 |
| Beispiel 34 | Beispiel 35 | Beispiel 36 |
| 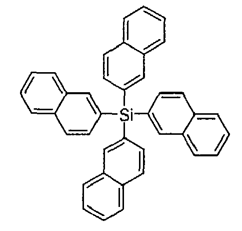 | 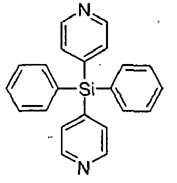 | 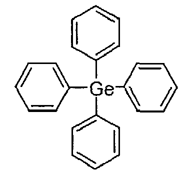 |
| Beispiel 37 | Beispiel 38 | Beispiel 39 |
| 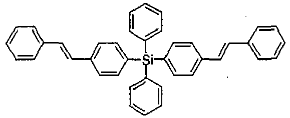 | 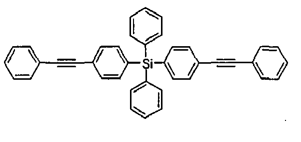 | 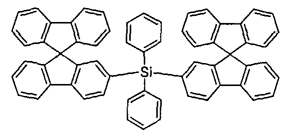 |
| Beispiel 40 | Beispiel 41 | Beispiel 42 |
| 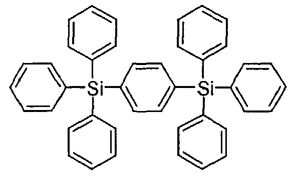 | 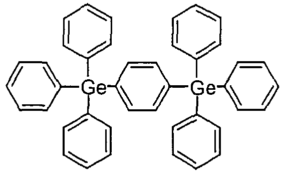 | 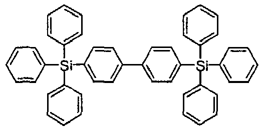 |
| Beispiel 43 | Beispiel 44 | Beispiel 45 |
| 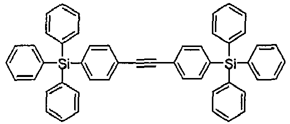 | 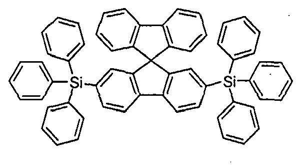 | 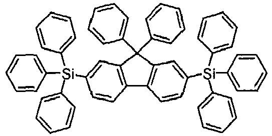 |
| Beispiel 46 | Beispiel 47 | Beispiel 48 |

Auch wenn dies aus der Beschreibung hervorgeht, sei hier nochmals explizit darauf verwiesen, dass die Struktureinheiten aus den Beispielen (1) bis (48) auch unsymmetrisch substituiert sein können, d. h. dass an einer Einheit unterschiedliche Substituenten R⁴ vorhanden sein können bzw. diese auch an unterschiedliche Positionen gebunden sein können. Bei prochiralen Struktureinheiten sind alle Möglichkeiten der Taktizität bzw. der Chiralität miterfasst.

Die Struktureinheiten gemäß Formel (2) bis (4) sind kovalenter Bestandteil des Matrixpolymers POLY1. Es hat sich gezeigt, dass ein Anteil im Bereich von 1 - 100 mol% dieser Wiederholeinheiten (bezogen auf alle Wiederholeinheiten im Polymer) hier gute Ergebnisse erzielt. Bevorzugt ist für POLY1 ein Anteil von 1 - 100 mol% Wiederholeinheiten gemäß Formel (2) bis (4). Besonders bevorzugt ist ein Anteil von 5-80 mol% Wiederholeinheiten gemäß Formel (2) bis (4), ganz besonders bevorzugt ist ein Anteil von 10-50 mol% Wiederholeinheiten gemäß Formel (2) bis (4).

Verbindungen gemäß Formel (5) sind Mischungs-Bestandteil von BLEND2 und BLEND3. Es hat sich gezeigt, dass ein Anteil im Bereich von 1-99 Gew.% dieser Verbindungen in der Mischung hier gute Ergebnisse erzielt. Bevorzugt ist für BLEND2 und BLEND3 ein Anteil von 1-99 Gew.% Verbindungen gemäß Formel (5). Besonders bevorzugt ist ein Anteil von 5-80 Gew.% gemäß Formel (5), ganz besonders bevorzugt ist ein Anteil von 10-50 Gew.% gemäß Formel (5).

Ein weiterer Aspekt der Erfindung ist das Einmischen von Verbindungen gemäß Formel (5) in BLEND1. Hier hat sich gezeigt, dass ein Gesamtanteil von 1-99 mol% Struktureinheiten gemäß Formel (1), bzw. gemäß Formeln (2) bis (5) gute Ergebnisse erzielt, unabhängig davon, ob diese Einheiten kovalent an das Polymer gebunden oder eingemischt sind. Bevorzugt ist hier also ein Gesamtanteil von 1 - 99 mol% Struktureinheiten gemäß Formel (1), bzw. gemäß Formeln (2) bis (5). Besonders bevorzugt ist ein Gesamtanteil von 5-80 mol% Struktureinheiten gemäß Formel (1), bzw. gemäß Formeln (2) bis (5), ganz besonders bevorzugt ist ein Gesamtanteil von 10-50 mol% Struktureinheiten gemäß Formel (1), bzw. gemäß Formeln (2) bis (5).

Die in BLEND1 und BLEND3 eingemischten Triplett-Emitter TRIP1, bzw. die in POLY2 (= BLEND2) einpolymerisierten Triplett-Emitter TRIP2 können aus verschiedenen metallorganischen bzw. anorganischen Substanzklassen ausgewählt werden, die bei Raumtemperatur aus dem Triplett-Zustand Licht emittieren können, also Phosphoreszenz statt Fluoreszenz zeigen: Dies sind zunächst vor allem Verbindungen, welche Schweratome, d. h. Atome aus dem Periodensystem der Elemente mit einer Ordnungszahl von mehr als 36, enthalten. Besonders geeignet sind hierfür Verbindungen, welche d- und f-Übergangsmetalle enthalten, die die o. g. Bedingung erfüllen. Ganz besonders bevorzugt sind hier entsprechende Struktureinheiten, welche Elemente der Gruppe 8 bis 10 (Ru, Os, Rh, Ir, Pd, Pt) enthalten. Ohne an eine spezielle Theorie gebunden sein zu wollen, werden im Sinne dieser Anmeldung alle emittierenden Verbindungen, die diese Elemente enthalten, als Triplett-Emitter bezeichnet.

Die Triplett-Emitter TRIP1 können niedermolekulare, oligomere, dendritische oder polymere Verbindungen sein. Da diese als Mischungsbestandteil (BLEND1 bzw. BLEND3) verarbeitet werden, muss eine ausreichende Löslichkeit in geeigneten Lösemitteln (z. B. Toluol, Xylol, Anisol, THF, etc.) gegeben sein, damit die Verarbeitung aus Lösung möglich ist. Als niedermolekulare Struktureinheiten kommen verschiedene Komplexe in Frage, welche beispielsweise in den Anmeldeschriften WO 02/068435, WO 02/081488, EP 1239526 und WO 04/026886 beschrieben sind. Als dendritische Strukturen kommen für TRIP1 bzw. TRIP3 Komplexe in Frage, wie beispielsweise in den Anmeldeschriften WO 99/21935, WO 01/059030 und WO 02/066552 beschrieben sind.

Der Triplett-Emitter TRIP2 wird kovalent in die Polymerkette von POLY2 (BLEND2) eingebaut. Um den Einbau von TRIP2 in POLY2 zu ermöglichen, müssen an TRIP2 funktionelle polymerisierbare Gruppen vorhanden sein. Beispiele für entsprechende bromierte Komplexe, die als Monomere in Polykondensationen (beispielsweise gemäß SUZUKI oder gemäß YAMAMOTO) eingesetzt werden können, werden in WO 02/068435 und in der nicht offen gelegten Anmeldung DE 10350606.3 beschrieben.

Die erfindungsgemäße Mischung BLEND1 wird erhalten, indem dem Polymer POLY1 ein Triplett-Emitter TRIP1 zugemischt werden.
Die erfindungsgemäße Mischung BLEND2 wird erhalten, indem dem Polymer POLY2 eine Verbindung gemäß Formel (5) zugemischt wird.
Die erfindungsgemäße Mischung BLEND3 wird erhalten, indem dem Polymer POLY3 eine Verbindung gemäß Formel (5), sowie ein Triplett-Emitter TRIP1 zugemischt werden.

Es kann außerdem bevorzugt sein, in BLEND1 bis BLEND3 noch weitere konjugierte, teilkonjugierte oder nicht-konjugierte Polymere, Oligomere, Dendrimere oder weitere niedermolekulare Verbindungen einzumischen. Die Zugabe weiterer Komponenten kann sich für manche Anwendungen als sinnvoll erweisen: So kann beispielsweise durch Zugabe einer elektronisch aktiven Substanz die Loch- bzw. Elektroneninjektion, der Loch- bzw. Elektronentransport oder das Ladungsgleichgewicht im entsprechenden Blend reguliert werden. Die Zusatzkomponente kann auch den Singulett-Triplett-Transfer verbessern. Jedoch auch die Zugabe elektronisch inerter Verbindungen kann hilfreich sein, um beispielsweise die Viskosität einer Lösung oder die Morphologie des gebildeten Films zu kontrollieren. Die so erhaltenen Blends sind ebenfalls Gegenstand der Erfindung.

Die Darstellung von BLEND1 bis BLEND3 erfolgt folgendermaßen: Die Einzelbestandteile werden in einem geeigneten Mischungsverhältnis zusammengegeben und in einem geeigneten Lösungsmittelsystem gelöst. Geeignete Lösemittel sind beispielsweise Toluol, Anisol, Xylole, Methylanisol, Methylnaphthalin, Chlorbenzol, cyclische Ether (z. B. Dioxan, THF, Methyldioxan), Amide (z. B. NMP, DMF) oder Mischungen dieser Lösemittel. Alternativ können die Bestandteile des Blends auch einzeln gelöst werden. Die Lösung des Blends erhält man in diesem Fall durch Zusammenfügen der Einzellösungen im geeigneten Mischungsverhältnis. Dabei findet der Lösevorgang bevorzugt in einer inerten Atmosphäre und gegebenenfalls bei erhöhter Temperatur statt. Der Blend wird im Allgemeinen nicht als Feststoff (durch nochmaliges Ausfällen) isoliert, sondern direkt aus Lösung weiter verarbeitet.
Ein geeignetes Verhältnis der einzelnen Komponenten ist beispielsweise eine Mischung, die insgesamt 1 - 99.5 mol%, bevorzugt 5-80 mol%, besonders bevorzugt 10-50 mol% Einheiten gemäß Formel (1), bzw. gemäß Formeln (2) bis (5) enthält und 0.1 - 95 mol%, bevorzugt 0.5 - 80 mol%, besonders bevorzugt 1 - 50 mol%, insbesondere 2-25 mol% TRIP1 und/oder TRIP2 enthält, wobei sich die Angaben auf die gesamt vorhandenen Einheiten (Blendbestandteile bzw. Wiederholeinheiten im Polymer) beziehen. Dies ist unabhängig davon,,ob die Komponenten kovalent an ein Polymer gebunden oder eingemischt sind.

Die erfindungsgemäßen Mischungen BLEND1 bis BLEND3 weisen gegenüber dem Stand der Technik folgende überraschende Vorteile auf:
- Die Effizienz der Lichtemission des Triplett-Emitters ist in erfindungsgemäßen Mischungen BLEND1 bis BLEND3 besser im Vergleich zu Mischungen gemäß Stand der Technik.
- Die Spannungen für den Betrieb der Leuchtdiode sind im Vergleich zum Stand der Technik niedriger.
- Mit Hilfe der neuartigen Mischungen sind effiziente Triplett-Devices aus Lösung für eine große Bandbreite roter und grüner Triplett-Emitter möglich. Dies ist ein überraschendes Ergebnis, da gemäß Stand der Technik für die einzelnen Farben (und teilweise selbst für verschiedene Emitter vergleichbarer Farbe) im Allgemeinen spezifische Matrizes benötigt werden.

Gegenstand der Erfindung sind weiterhin Lösungen und Formulierungen eines erfindungsgemäßen Blends in einem oder mehreren Lösungsmitteln. Wie solche Lösungen hergestellt werden können, ist beispielsweise in WO 02/072714, in WO 03/019694 und in der darin zitierten Literatur beschrieben. Diese Lösungen können verwendet werden, um dünne Polymerschichten herzustellen, zum Beispiel durch Flächenbeschichtungsverfahren (z. B. Spin-coating) oder Druckverfahren (z. B. InkJet Printing).

Die Mischungen BLEND1 bis BLEND3 können in PLEDs verwendet werden, insbesondere als Elektrolumineszenzmaterialien (= emittierende Materialien). Für den Bau von PLEDs wird in der Regel ein allgemeines Verfahren verwendet, das entsprechend für den Einzelfall anzupassen ist. Ein solches Verfahren wurde beispielsweise in WO 04/037887 ausführlich beschrieben.

Gegenstand der Erfindung ist daher auch die Verwendung einer erfindungsgemäßen Mischung BLEND1 bis BLEND3 in einer PLED als Elektrolumineszenzmaterial.

Gegenstand der Erfindung ist ebenfalls eine PLED mit einer oder mehreren Schichten, wobei mindestens eine dieser Schichten, bevorzugt eine Emissionsschicht, mindestens eine erfindungsgemäße Mischung BLEND1, BLEND2 und/oder BLEND3 enthält.

Im vorliegenden Anmeldetext und in den folgenden Beispielen wird auf die Verwendung erfindungsgemäßer Mischungen BLEND1 bis BLEND3 in Bezug auf PLEDs und die entsprechenden Displays abgezielt. Trotz dieser Beschränkung der Beschreibung ist es für den Fachmann ohne weiteres erfinderisches Zutun möglich, die erfindungsgemäßen Polymere oder Blends auch für weitere Verwendungen in anderen elektronischen Devices (Vorrichtungen) zu benutzen, z. B. für organische Solarzellen (O-SCs), nicht-lineare Optik, Frequenzverdopplung (Up-conversion), organische optische Detektoren, organische Feld-Quench-Devices (O-FQDs) oder auch organische Laserdioden (O-Laser), um nur einige Anwendungen zu nennen. Auch diese sind Gegenstand der vorliegenden Erfindung.

Die Erfindung wird durch die nachfolgenden Beispiele näher erläutert, ohne sie dadurch einschränken zu wollen.

### Beispiele

### Beispiel 1: Synthese von Herstellung von 4,4'-Dibromtetraphenylsilan (Monomer Si1)

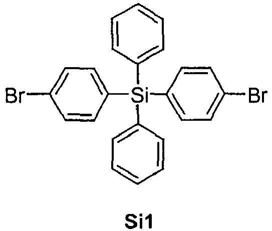

In einem ausgeheizten 1000 mL Vierhalskolben mit Innenthermometer, Rührkern, Argon-Überlagerung und Tropftrichter wurden 33.9 g (144 mmol) 1,4-Dibrombenzol in 300 mL absolutem THF gelöst und auf -75 °C gekühlt. Es wurden 90 mL (144 mmol) n-Butyllithium (1.6 M in Hexanfraktion) innerhalb von 30 Minuten zugetropft, anschließend wurde 1 h bei dieser Temperatur gerührt. Dann wurden bei -75 °C 15.3 mL (18.3 g, 72 mmol) Diphenyldichlorsilan in 60 mL THF zugetropft und über Nacht auf Raumtemperatur aufgewärmt. Das Lösemittel wurde entfernt, der Rückstand in Dichlormethan suspendiert und filtriert. Das Lösemittel wurde vom Filtrat entfernt, und das Produkt wurde zweimal aus Butanol und zweimal aus Heptan/Toluol umkristallisiert. Man erhielt 16.8 g (47 % d. Th.) in einer Reinheit von 99.9 % gemäß HPLC. ¹H-NMR (CDCl₃): [ppm] = 7.51 (m, 8H), 7.55 (t, ³J_{HH} = 7.7 Hz, 2 H), 7.38 (m, 8H).

### Beispiel 2: Synthese der Co-Monomere für die Polymere

Die Synthese der weiteren verwendeten Co-Monomere ist in WO 02/077060 und der darin zitierten Literatur ausführlich beschrieben. Das im Folgenden verwendete Monomer **M1** sei hier der Übersichtlichkeit halber nochmals abgebildet:

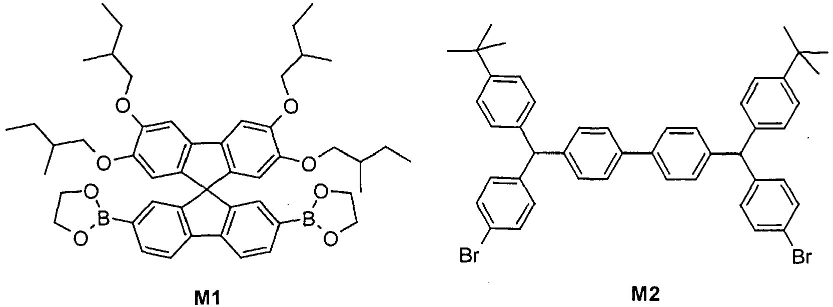

### Beispiel 3: Synthese von Polymer P1 (POLY1)

Die Synthese erfolgte gemäß dem in WO 03/048224 beschriebenen Verfahren. Es wurden eingesetzt: 1.6013 g (2 mmol) Monomer **M1,** 0.9886 g (2 mmol) Monomer **Si1** und 2.03 g (2.2 Äquivalente) Kaliumphosphat Hydrat in 19 mL Dioxan, 6 mL Toluol und 12 mL H₂O. Als Katalysator wurden verwendet: 0.45 mg Pd(OAc)₂ und 3.65 mg P(o-tolyl)₃. Nach Aufarbeitung wurden 1.44 g Polymer erhalten, das ein Molekulargewicht Mₙ 57000 und M_{w} 192000 aufwies (GPC in THF mit Polystyrol-Standard). Die Synthese des Polymers **P2** erfolgte entsprechend.

### Beispiel 4: Struktureinheiten TRIP1 zur Verwendung in Blends

Bei den hier beispielhaft verwendeten Verbindungen **TRIP1** handelt es sich um Derivate von tris-(Phenylpyridyl)iridium(III). Die Synthese dieser Verbindungen ist in WO 02/081488 und WO 04/026886 beschrieben. Zur Übersicht sind die hier verwendeten Iridium-Komplexe im Folgenden nochmals abgebildet:

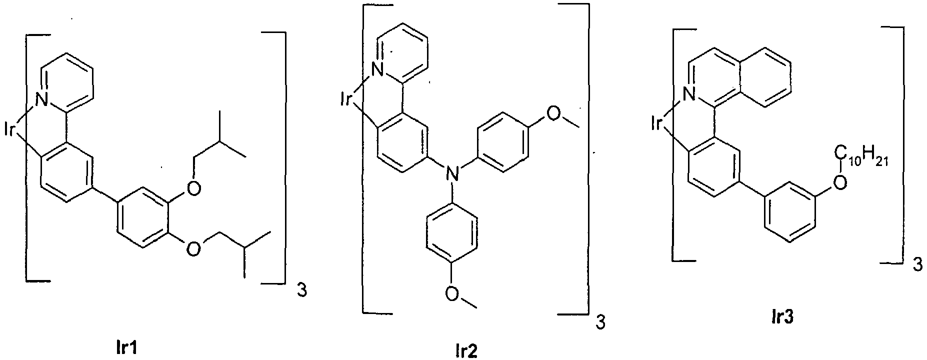

### Beispiel 5: Herstellung der Blends

Die Herstellung der Mischungen erfolgte durch Lösen der Blendbestandteile im gewünschten Verhältnis und in der gewünschten Konzentration in einem geeigneten Lösemittel. Als Lösemittel wurde hier Toluol verwendet. Dabei wurde der Lösevorgang in einer inerten Atmosphäre bei 60 °C durchgeführt. Die Lösung wurde ohne Isolierung der Mischung (nochmaliges Ausfällen der Feststoffanteile) direkt verarbeitet.

### Beispiel 6: Herstellung der polymeren Leuchtdioden (PLEDs)

Wie PLEDs dargestellt werden können, ist in WO 04/037887 und der darin zitierten Literatur ausführlich beschrieben.

### Beispiel 7: Device-Beispiele

Tabelle 1 gibt eine Übersicht über verschiedene Blends aus Polymeren, wobei jeweils noch die Zusammensetzung der Polymere aufgeführt ist, und Triplettemittern.

**Tabelle 1: Deviceergebnisse mit erfindungsgemäßen Blends**

| Blend | Polymer | Polymerzusammensetzung | Triplettemitter^{a} | Max. Eff. | U@ 100 cd/m² | CIE x/y^{b} | Lebensdauer (100)^{c} |
|---|---|---|---|---|---|---|---|
| Blend 1 | **P1** | 50% **Si1**, 50% **M1** | 8% **Ir1** | 20.7 cd/A | 6.9 V | 0.39 / 0.58 | 700 hrs |
| Blend 2 | **P1** | 50% **Si1**, 50% **M1** | 20% **Ir1** | 23.4 cd/A | 5.3 V | 0.39 / 0.58 | 2000 hrs |
| Blend 3 | **P1** | 50% **Si1,** 50% **M1** | 8% **Ir2** | 4.21 cd/A | 10.5 V | 0.60 / 0.40 | 100 hrs |
| Blend 4 | **P1** | 50% **Si1,** 50% **M1** | 20% **Ir2** | 10.8 cd/A | 6.6 V | 0.62 / 0.38 | |
| Blend 5 | **P2** | 10% **Si1,** 80% **M1,** 10% **M2** | 20% **Ir2** | 9.0 cd/A | 5.3 V | 0.62 / 0.38 | 64 hrs |
| Blend 6 | **P1** | 50% **Si1,** 50% **M1** | 8% **Ir3** | 3.78 cd/A | 8.1 V | 0.68/0.32 | 90 hrs |
| Blend 7 | **P1** | 50% **Si1,** 50% **M1** | 20% **Ir3** | 3.17 cd/A | 9.0 V | 0.68 / 0.32 | 110 hrs |
| Blend 8 | **P2** | 10% **Si1,** 80% **M1,** 10% **M2** | 8% **Ir3** | 4.69 cd/A | 4.8 V | 0.68/0.32 | 1700 hrs |

| | | | | | | | |
|---|---|---|---|---|---|---|---|
| ^{a} Die Konzentration des Triplettemitters in der Matrix ist angegeben in Gew.%, d. h. 20% Triplettemitter in Polymer **P1** bzw. **P2** bedeuten 20 Gewichtsanteile Emitter und 80 Gewichtsanteile **P1** ^{b} CIE-Koordinaten: Chromatizitäts-Koordinaten der Commission Internationale de l'Eclairage von 1931 ^{c} Die Lebensdauer wurde mit einem Beschleunigungsfaktor von 2 auf eine einheitliche Anfangsleuchtdichte von 100 cd/m² extrapoliert. | | | | | | | |

## Patentansprüche

1. Mischungen (Blends), enthaltend
(A) mindestens ein Polymer,
(B) mindestens eine Struktureinheit, die mindestens ein Element der 4. Hauptgruppe (Gruppe 14 gemäß IUPAC) ungleich Kohlenstoff enthält, und
(C) mindestens einen Triplett-Emitter, wobei
die Struktureinheit, die mindestens ein Element der 4. Hauptgruppe ungleich Kohlenstoff enthält,
mindestens eine Struktureinheit gemäß den Formeln (2) bis (5) enthält, 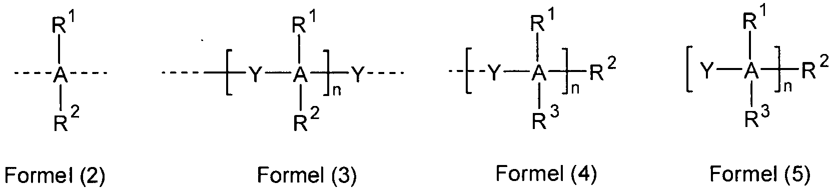 wobei für die Symbole gilt:
A ist bei jedem Auftreten gleich oder verschieden Si, Ge, Sn oder Pb;
Y ist bei jedem Auftreten gleich oder verschieden ein aromatisches oder heteroaromatisches Ringsystem mit 2 bis 40 C-Atomen, das durch einen oder mehrere Reste R⁴ substituiert sein kann, eine Vinylgruppe -CR⁴=CR⁴- bzw. -CR⁴=C(R⁴)₂, eine Acetylengruppe -C≡C- bzw. -C≡CR⁴ oder eine Kombination aus 2 bis 5 dieser Gruppen; dabei steht Y in den Formeln (3) und (4) für bivalente Gruppen und in Formel (5) für eine monovalente Gruppe;
R¹, R², R³ ist bei jedem Auftreten gleich oder verschieden H, F, CN, N(R⁴)₂, eine geradkettige, verzweigte oder cyclische Alkyl-, Alkoxy- oder Thioalkoxygruppe mit 1 bis 40 C-Atomen, die mit R⁴ substituiert sein kann, wobei ein oder mehrere nicht benachbarte CH₂-Gruppen durch -R⁵C=CR⁵-, -C≡C-, Si(R⁵)₂, Ge(R⁵)₂, Sn(R⁵)₂, C=O, C=S, C=Se, C=NR⁵, -O-, -S-, -NR⁵- oder -CONR⁵- ersetzt sein können und wobei ein oder mehrere H-Atome durch F, Cl, Br, I, CN, OH oder NO₂ ersetzt sein können, oder ein aromatisches bzw. heteroaromatisches Ringsystem oder eine Aryloxy- oder Heteroaryloxygruppe jeweils mit 2 bis 40 aromatischen C-Atomen, wobei ein oder mehrere H-Atome durch F, Cl, Br, I, CN, OH oder NO₂ ersetzt sein können oder die durch einen oder mehrere Reste R⁴ substituiert sein kann, oder eine Kombination aus 2 bis 5 dieser Systeme; dabei können zwei oder mehrere Substituenten R¹, R² und/oder R³ miteinander ein weiteres mono- oder polycyclisches, aliphatisches oder aromatisches Ringsystem aufspannen;
R⁴ ist bei jedem Auftreten gleich oder verschieden H, F, Cl, Br, I, CN, OH, NO₂ eine geradkettige, verzweigte oder cyclische Alkyl-, Alkoxy- oder Thioalkoxygruppe mit 1 bis 22 C-Atomen, in der auch ein oder mehrere nicht benachbarte C-Atome durch -R⁵C=CR⁵-, -C=C-, Si(R⁵)₂, Ge(R⁵)₂, Sn(R⁵)₂, -NR⁵-, -O-, -S-, -CO-O-, -O-CO-O- ersetzt sein können, wobei auch ein oder mehrere H-Atome durch F, Cl, Br, I, CN, OH oder NO₂ ersetzt sein können, eine Aryl-, Heteroaryl- oder Aryloxygruppe mit 1 bis 40 C-Atomen, welche auch durch ein oder mehrere Reste R⁵ substituiert sein können, oder OH, N(R⁵)₂, B(R⁵)₂ oder Si(R⁵)₃;
R⁵ ist bei jedem Auftreten gleich oder verschieden H oder ein aliphatischer oder aromatischer Kohlenwasserstoffrest mit 1 bis 20 C-Atomen,
n ist bei jedem Auftreten gleich oder verschieden 1, 2, 3 oder 4;
die gestrichelte Bindung stellt die Anknüpfung an das Polymer dar;
**dadurch gekennzeichnet, dass** die Einheiten gemäß Formel (5) und/oder der Triplett-Emitter eingemischt sind.

2. Mischungen BLEND1 gemäß Anspruch 1, enthaltend
(A) 5 - 99.9 Gew.% mindestens eines Polymers POLY1, enthaltend 1 - 100 mol% einer oder mehrerer Wiederholeinheiten gemäß Formeln (2) bis (4); und
(B) 0.1-95 Gew.% eines oder mehrerer Triplett-Emitter (TRIP1).

3. Mischungen BLEND1 gemäß Anspruch 2, **dadurch gekennzeichnet, dass** der Anteil der Struktureinheiten gemäß Formel (2) bis (4) im Polymer POLY1 im Bereich von 5-80 mol% liegt.

4. Mischungen BLEND2 gemäß Anspruch 1, enthaltend
(A) 0.5-99 Gew.% mindestens eines Polymers POLY2, enthaltend 0.1-100 mol% eines oder mehrerer Triplett-Emitter (TRIP2) kovalent gebunden; und
(B) 1-99.5 Gew.% mindestens einer Verbindung gemäß Formel (5), die in der Lage ist, bei Raumtemperatur glasartige Schichten zu bilden.

5. Mischungen BLEND3 gemäß Anspruch 1, enthaltend
(A) 0.5-98.5 Gew.% mindestens eines Polymers POLY3;
(B) 1-99 Gew.% mindestens einer Verbindung gemäß Formel (5), die in der Lage ist, bei Raumtemperatur glasartige Schichten zu bilden; und
(C) 0.1-95 Gew.% eines oder mehrerer Triplett-Emitter (TRIP1).

6. Mischungen BLEND2 oder BLEND3 gemäß Anspruch 4 oder 5, **dadurch gekennzeichnet, dass** der Anteil Verbindungen gemäß Formel (5) im Blend im Bereich von 5-80 Gew.% liegt.

7. Mischungen gemäß einem oder mehreren der Ansprüche 1 bis 6, **dadurch gekennzeichnet, dass** die Polymere POLY1 bis POLY3 konjugiert oder teilkonjugiert sind.

8. Mischungen gemäß einem oder mehreren der Ansprüche 1 bis 7, **dadurch gekennzeichnet, dass** die Polymere POLY1, POLY2 und POLY3 außer den Einheiten gemäß Formeln (2) bis (4) (in POLY1) und dem Triplett-Emitter TRIP2 (in POLY2) weitere Strukturelemente enthalten.

9. Mischungen gemäß Anspruch 8, **dadurch gekennzeichnet, dass** die weiteren Struktureinheiten das Polymergrundgerüst bilden oder die Ladungsinjektions-und/oder Ladungstransporteigenschaften verbessern.

10. Mischungen gemäß einem oder mehreren der Ansprüche 1 bis 9, **dadurch gekennzeichnet, dass** A gleich oder verschieden bei jedem Auftreten für Si oder Ge steht.

11. Mischungen gemäß einem oder mehreren der Ansprüche 1 bis 10, **dadurch gekennzeichnet, dass** Y gleich oder verschieden bei jedem Auftreten für ein aromatisches Ringsystem mit 2 bis 40 C-Atomen, das durch einen oder mehrere Reste R⁴ substituiert sein kann oder eine durch R⁴ substituierte oder unsubstituierte Stilben- bzw. Tolangruppe steht.

12. Mischungen gemäß einem oder mehreren der Ansprüche 1 bis 11, **dadurch gekennzeichnet, dass** mindestens einer der Substituenten R¹ bis R³ ein aromatisches oder heteroaromatisches Ringsystem mit 2 bis 40 C-Atomen darstellt, das mit einem oder mehreren Substituenten R⁴ substituiert sein kann.

13. Mischungen gemäß einem oder mehreren der Ansprüche 1 bis 12, **dadurch gekennzeichnet, dass** der Index n gleich oder verschieden bei jedem Auftreten 1, 2 oder 3 ist.

14. Mischungen gemäß einem oder mehreren der Ansprüche 1 bis 13, **dadurch gekennzeichnet, dass** die Einheiten gemäß Formel (2) bis (5) symmetrisch aufgebaut sind.

15. Mischungen gemäß einem oder mehreren der Ansprüche 1 bis 14, **dadurch gekennzeichnet, dass** die Einheiten gemäß Formel (2) bis (5) aus den folgenden Beispielen (1) bis (48) ausgesucht sind:
| | | |
|---|---|---|
| 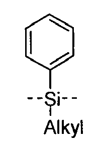 | 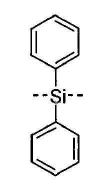 | 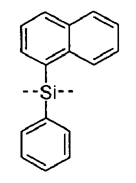 |
| Beispiel 1 | Beispiel 2 | Beispiel 3 |
| 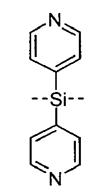 | 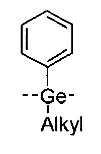 | 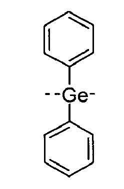 |
| Beispiel 4 | Beispiel 5 | Beispiel 6 |
| 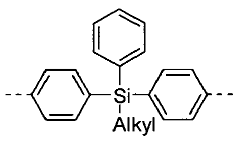 | 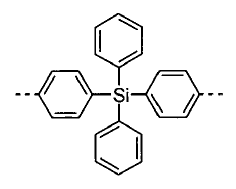 | 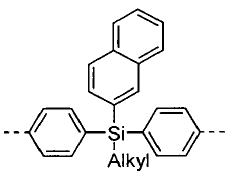 |
| Beispiel 7 | Beispiel 8 | Beispiel 9 |
| 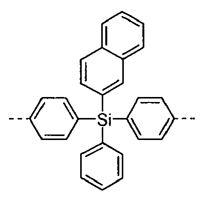 | 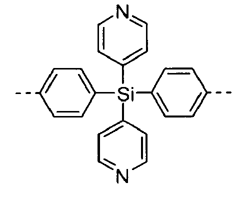 | 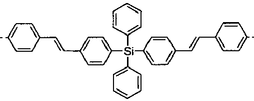 |
| Beispiel 10 | Beispiel 11 | Beispiel 12 |
| 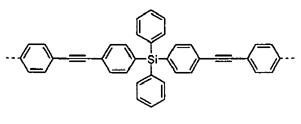 | 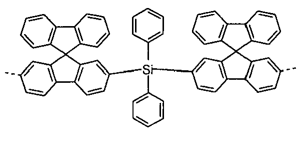 | 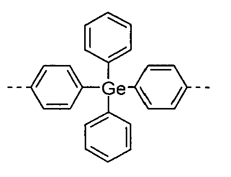 |
| Beispiel 13 | Beispiel 14 | Beispiel 15 |
| 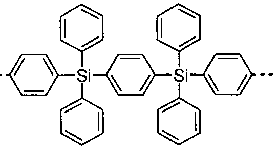 | 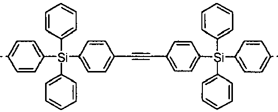 | 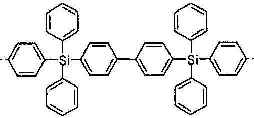 |
| Beispiel 16 | Beispiel 17 | Beispiel 18 |
| 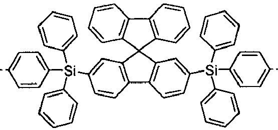 | 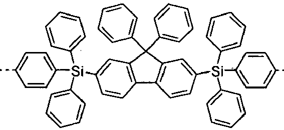 | 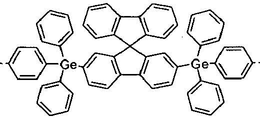 |
| Beispiel 19 | Beispiel 20 | Beispiel 21 |
| 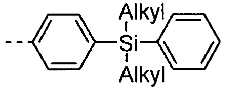 | 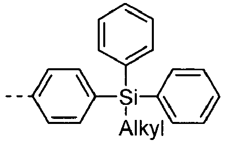 | 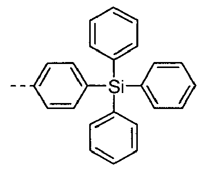 |
| Beispiel 22 | Beispiel 23 | Beispiel 24 |
| 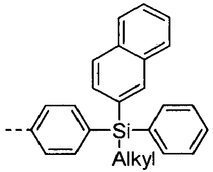 | 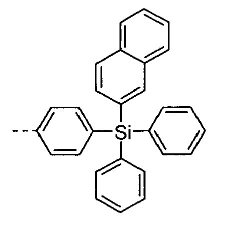 | 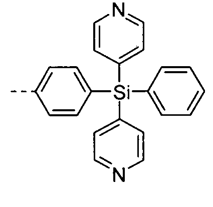 |
| Beispiel 25 | Beispiel 26 | Beispiel 27 |
| 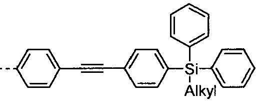 | 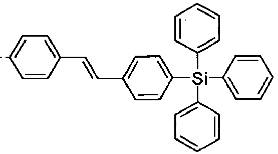 | 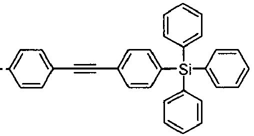 |
| Beispiel 28 | Beispiel 29 | Beispiel 30 |
| 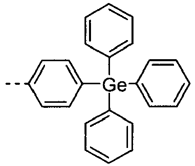 | 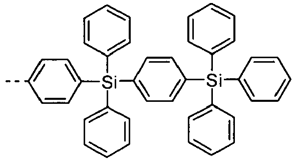 | 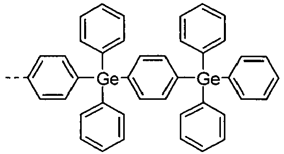 |
| Beispiel 31 | Beispiel 32 | Beispiel 33 |
| 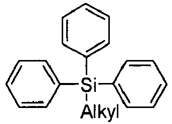 | 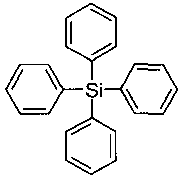 | 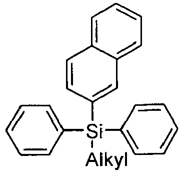 |
| Beispiel 34 | Beispiel 35 | Beispiel 36 |
| 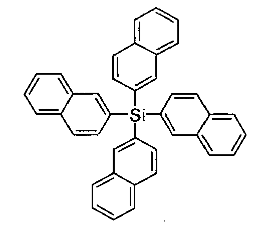 | 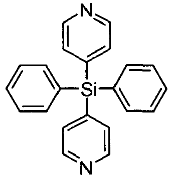 | 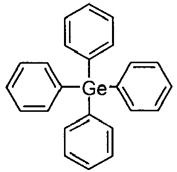 |
| Beispiel 37 | Beispiel 38 | Beispiel 39 |
| 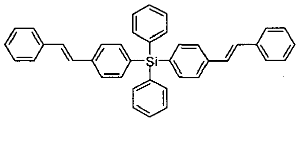 | 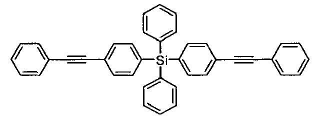 | 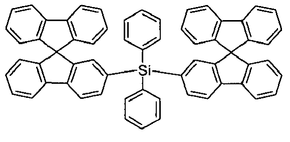 |
| Beispiel 40 | Beispiel 41 | Beispiel 42 |
| 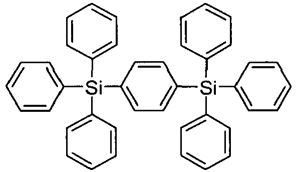 | 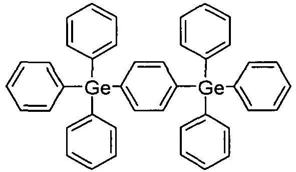 | 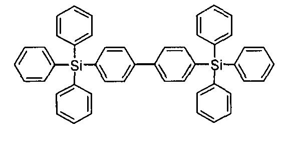 |
| Beispiel 43 | Beispiel 44 | Beispiel 45 |
| 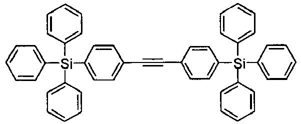 | 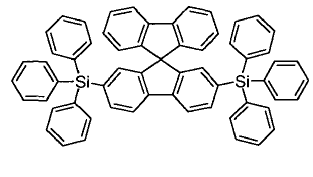 | 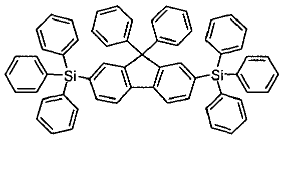 |
| Beispiel 46 | Beispiel 47 | Beispiel 48 |

16. Mischungen gemäß einem oder mehreren der Ansprüche 1 bis 15, **dadurch gekennzeichnet, dass** Verbindungen gemäß Formel (5) in BLEND1 eingemischt werden.

17. Mischungen gemäß einem oder mehreren der Ansprüche 1 bis 16, **dadurch gekennzeichnet, dass** die Triplett-Emitter mindestens ein Atom aus dem Periodensystem der Elemente mit einer Ordnungszahl von mehr als 36 enthalten.

18. Mischungen gemäß Anspruch 17, **dadurch gekennzeichnet, dass** die Triplett-Emitter d- und/oder f-Übergangsmetalle enthalten.

19. Mischungen gemäß Anspruch 18, **dadurch gekennzeichnet, dass** die Triplett-Emitter mindestens ein Element der Gruppe 8 bis 10 enthalten.

20. Mischungen gemäß einem oder mehreren der Ansprüche 1 bis 19, **dadurch gekennzeichnet, dass** in BLEND1 bis BLEND3 noch weitere konjugierte, teilkonjugierte oder nicht-konjugierte Polymere, Oligomere, Dendrimere und/oder weitere niedermolekulare Verbindungen eingemischt werden.

21. Verwendung einer Mischung gemäß einem oder mehreren der Ansprüche 1 bis 20 in einer organischen elektronischen Vorrichtung.

22. Organische elektronische Vorrichtung mit einer oder mehreren Schichten, wobei mindestens eine dieser Schichten mindestens eine Mischung gemäß einem oder mehreren der Ansprüche 1 bis 20 enthält.

23. Organische elektronische Vorrichtung gemäß Anspruch 22, **dadurch gekennzeichnet, dass** es sich um organische Leuchtdioden (PLED), organische Solarzellen (O-SCs), nicht-lineare optische Vorrichtungen, Vorrichtungen zur Frequenzverdopplung, organische optische Detektoren, organische Feld-Quench-Devices oder organische Laserdioden (O-Laser) handelt.

## Claims

1. Mixtures (blends) comprising
(A) at least one polymer,
(B) at least one structural unit which contains at least one element from main group 4 (group 14 in accordance with IUPAC) other than carbon, and
(C) at least one triplet emitter, where
the structural unit which contains at least one element from main group 4 other than carbon contains at least one structural unit of the formulae (2) to (5). 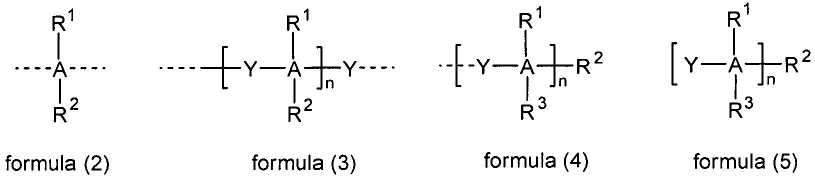 where the following applies to the symbols:
A is on each occurrence, identically or differently, Si, Ge, Sn or Pb;
Y is on each occurrence, identically or differently, an aromatic or hetero-aromatic ring system having 2 to 40 C atoms, which may be substituted by one or more radicals R⁴, a vinyl group -CR⁴=CR⁴- or -CR⁴=C(R⁴)₂, an acetylene group -C≡C- or -C≡CR⁴ or a combination of 2 to 5 of these groups; Y here stands for divalent groups in the formulae (3) and (4) and for a monovalent group in formula (5);
R¹, R², R³ are on each occurrence, identically or differently, H, F, CN, N(R⁴)₂, a straight-chain, branched or cyclic alkyl, alkoxy or thioalkoxy group having 1 to 40 C atoms, which may be substituted by R⁴, where one or more non-adjacent CH₂ groups may be replaced by -R⁵C=CR⁵-, -C=C-, Si(R⁵)₂, Ge(R⁵)₂, Sn(R⁵)₂, C=O, C=S, C=Se, C=NR⁵, -O-, -S-, -NR⁵- or -CONR⁵- and where one or more H atoms may be replaced by F, Cl, Br, I, CN, OH or NO₂, or an aromatic or heteroaromatic ring system or an aryloxy or heteroaryloxy group, in each case having 2 to 40 aromatic C atoms, where one or more H atoms may be replaced by F, Cl, Br, I, CN, OH or NO₂ or which may be substituted by one or more radicals R⁴, or a combination of 2 to 5 of these systems; two or more substituents R¹, R² and/or R³ here may form a further mono- or polycyclic, aliphatic or aromatic ring system with one another;
R⁴ is on each occurrence, identically or differently, H, F, Cl, Br, I, CN, OH, NO₂, a straight-chain, branched or cyclic alkyl, alkoxy or thioalkoxy group having 1 to 22 C atoms, in which, in addition, one or more non-adjacent C atoms may be replaced by -R⁵C=CR⁵-, -C≡C-, Si(R⁵)₂, Ge(R⁵)2, Sn(R⁵)2, -NR⁵-, -O-, -S-, -CO-O-, -O-CO-O-, where, in addition, one or more H atoms may be replaced by F, Cl, Br, I, CN, OH or NO₂, an aryl, heteroaryl or aryloxy group having 1 to 40 C atoms, which, in addition, may be substituted by one or more radicals R⁵, or OH, N(R⁵)₂, B(R⁵)₂ or Si(R⁵)₃;
R⁵ is on each occurrence, identically or differently, H or an aliphatic or aromatic hydrocarbon radical having 1 to 20 C atoms,
n is on each occurrence, identically or differently, 1, 2, 3 or 4;
the dashed bond represents the link to the polymer;
**characterised in that** the units of the formula (5) and/or the triplet emitter are mixed in.

2. Mixtures BLEND1 according to Claim 1, comprising
(A) 5 - 99.9% by weight of at least one polymer POLY1 containing 1 - 100 mol% of one or more recurring units of the formulae (2) to (4); and
(B) 0.1 - 95% by weight of one or more triplet emitters (TRIP1).

3. Mixtures BLEND1 according to Claim 2, **characterised in that** the proportion of the structural units of the formulae (2) to (4) in polymer POLY1 is in the range 5 - 80 mol%.

4. Mixtures BLEND2 according to Claim 1, comprising
(A) 0.5 - 99% by weight of at least one polymer POLY2 containing 0.1 - 100 mol% of one or more covalently bonded triplet emitters (TRIP2); and
(B) 1 - 99.5% by weight of at least one compound of the formula (5) which is capable of forming glass-like layers at room temperature.

5. Mixtures BLEND3 according to Claim 1, comprising
(A) 0.5 - 98.5% by weight of at least one polymer POLY3;
(B) 1 - 99% by weight of at least one compound of the formula (5) which is capable of forming glass-like layers at room temperature; and
(C) 0.1 - 95% by weight of one or more triplet emitters (TRIP1).

6. Mixtures BLEND2 or BLEND3 according to Claim 4 or 5, **characterised in that** the proportion of compounds of the formula (5) in the blend is in the range 5 - 80% by weight.

7. Mixtures according to one or more of Claims 1 to 6, **characterised in that** polymers POLY1 to POLY3 are conjugated or partially conjugated.

8. Mixtures according to one or more of Claims 1 to 7, **characterised in that** polymers POLY1, POLY2 and POLY3 contain further structural elements in addition to the units of the formulae (2) to (4) (in POLY1) and the triplet emitter TRIP2 (in POLY2).

9. Mixtures according to Claim 8, **characterised in that** the further structural units form the polymer backbone or improve the charge-injection and/or charge-transport properties.

10. Mixtures according to one or more of Claims 1 to 9, **characterised in that** A stands, identically or differently on each occurrence, for Si or Ge.

11. Mixtures according to one or more of Claims 1 to 10, **characterised in that** Y stands, identically or differently on each occurrence, for an aromatic ring system having 2 to 40 C atoms, which may be substituted by one or more radicals R⁴, or a stilbene or tolan group which is substituted by R⁴ or is unsubstituted.

12. Mixtures according to one or more of Claims 1 to 11, **characterised in that** at least one of the substituents R¹ to R³ represents an aromatic or heteroaromatic ring system having 2 to 40 C atoms, which may be substituted by one or more substituents R⁴.

13. Mixtures according to one or more of Claims 1 to 12, **characterised in that** the index n is, identically or differently on each occurrence, 1, 2 or 3.

14. Mixtures according to one or more of Claims 1 to 13, **characterised in that** the units of the formulae (2) to (5) have a symmetrical structure.

15. Mixtures according to one or more of Claims 1 to 15, **characterised in that** the units of the formulae (2) to (5) are selected from the following Examples (1) to (48):
| | | |
|---|---|---|
| 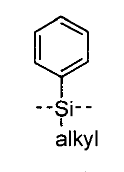 | 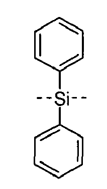 | 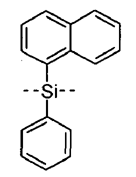 |
| Example 1 | Example 2 | Example 3 |
| 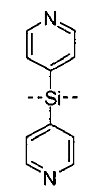 | 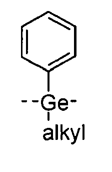 | 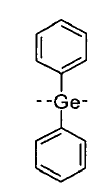 |
| Example 4 | Example 5 | Example 6 |
| 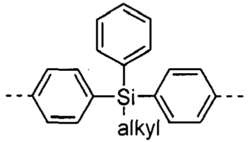 | 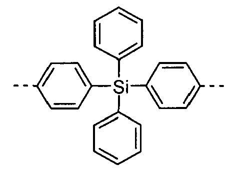 | 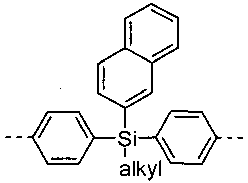 |
| Example 7 | Example 8 | Example 9 |
| 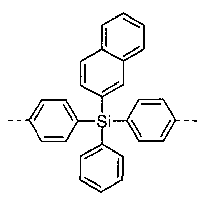 | 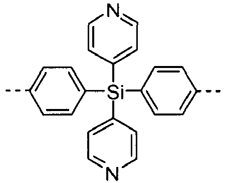 | 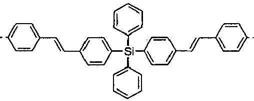 |
| Example 10 | Example 11 | Example 12 |
| 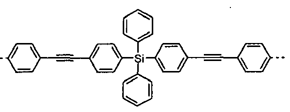 | 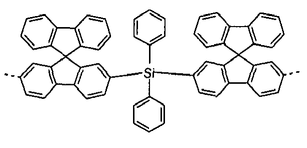 | 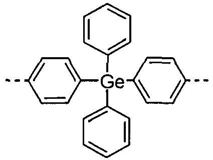 |
| Example 13 | Example 14 | Example 15 |
| 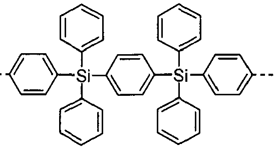 | 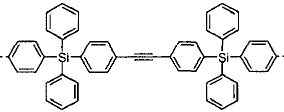 | 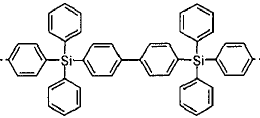 |
| Example 16 | Example 17 | Example 18 |
| 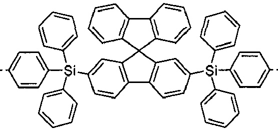 | 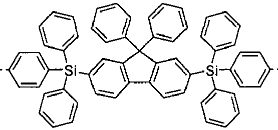 | 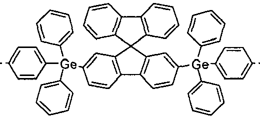 |
| Example 19 | Example 20 | Example 21 |
| 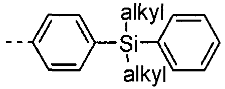 | 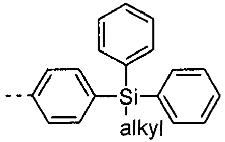 | 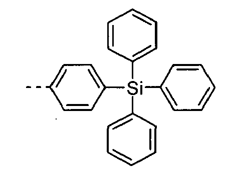 |
| Example 22 | Example 23 | Example 24 |
| 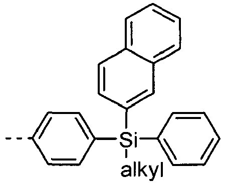 | 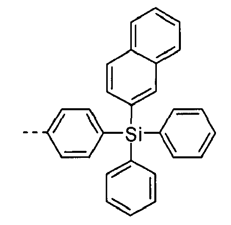 | 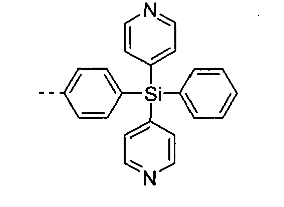 |
| Example 25 | Example 26 | Example 27 |
| 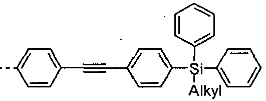 | 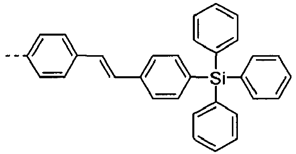 | 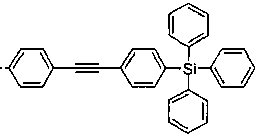 |
| Example 28 | Example 29 | Example 30 |
| 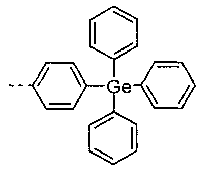 | 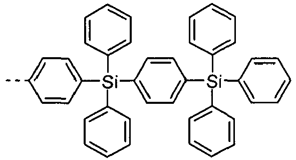 | 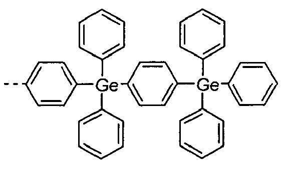 |
| Example 31 | Example 32 | Example 33 |
| 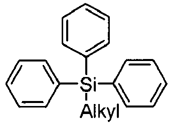 | 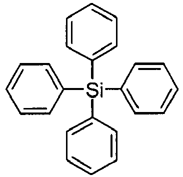 | 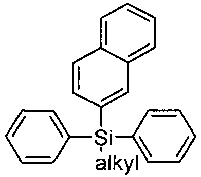 |
| Example 34 | Example 35 | Example 36 |
| 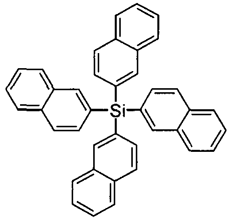 | 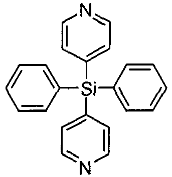 | 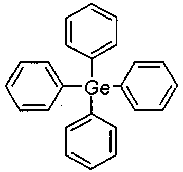 |
| Example 37 | Example 38 | Example 39 |
| 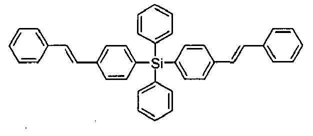 | 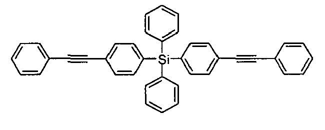 | 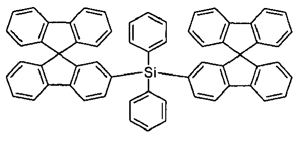 |
| Example 40 | Example 41 | Example 42 |
| 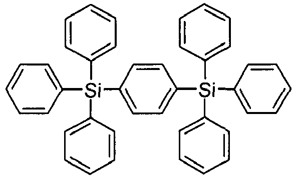 | 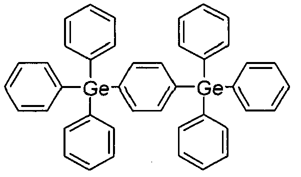 | 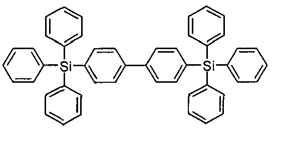 |
| Example 43 | Example 44 | Example 45 |
| 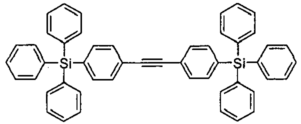 | 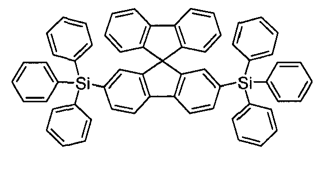 | 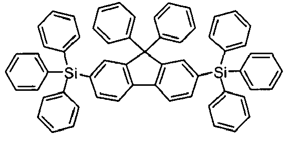 |
| Example 46 | Example 47 | Example 48 |

16. Mixtures according to one or more of Claims 1 to 15, **characterised in that** compounds of the formula (5) are mixed into BLEND1.

17. Mixtures according to one or more of Claims 1 to 16, **characterised in that** the triplet emitters contain at least one atom from the Periodic Table of the Elements having an atomic number of greater than 36.

18. Mixtures according to Claim 17, **characterised in that** the triplet emitters contain d and/or f transition metals.

19. Mixtures according to Claim 18, **characterised in that** the triplet emitters contain at least one element from groups 8 to 10.

20. Mixtures according to one or more of Claims 1 to 19, **characterised in that** further conjugated, partially conjugated or non-conjugated polymers, oligomers, dendrimers and/or further low-molecular-weight compounds are mixed into BLEND1 to BLEND3.

21. Use of a mixture according to one or more of Claims 1 to 20 in an organic electronic device.

22. Organic electronic device having one or more layers, where at least one of these layers comprises at least one mixture according to one or more of Claims 1 to 20.

23. Organic electronic device according to Claim 22, **characterised in that** it is an organic light-emitting diode (PLED), organic solar cell (O-SC), non-linear optical device, device for frequency doubling, organic optical detector, organic fieldquench device or organic laser diode (O-laser).

## Revendications

1. Mélanges (blends) comprenant:
(A) au moins un polymère,
(B) au moins une unité structurelle qui contient au moins un élément pris parmi un groupe principal 4 (groupe 14 conformément à IUPAC) autre que carbone, et
(C) au moins un émetteur de triplet, où :
l'unité structurelle qui contient au moins un élément pris parmi le groupe principal 4 autre que le carbone contient au moins une unité structurelle des formules (2) à (5) : 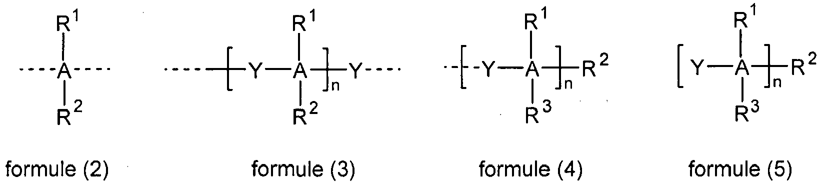 dans lesquelles ce qui suit s'applique aux symboles :
A est pour chaque occurrence, de manière identique ou différente, Si, Ge, Sn ou Pb ;
Y est pour chaque occurrence, de manière identique ou différente, un système de cycle aromatique ou hétéroaromatique comportant 2 à 40 atomes de C, lequel peut être substitué par un radical ou plusieurs radicaux R⁴, un groupe vinyle -CR⁴=CR⁴- ou -CR⁴=C(R⁴)₂, un groupe acétylène -C≡C- ou -C≡CR⁴ ou une combinaison de 2 à 5 de ces groupes ; Y représente ici des groupes divalents dans les formules (3) et (4) et un groupe monovalent dans la formule (5) ;
R¹, R², R³ sont pour chaque occurrence, de manière identique ou différente, H, F, CN, N(R⁴)₂, un groupe alkyle, alcoxy ou thioalcoxy en chaîne droite, ramifié ou cyclique comportant 1 à 40 atome(s) de C, lequel peut être substitué par R⁴, où un ou plusieurs groupe(s) CH₂ non adjacents peut/peuvent être remplacé(s) par -R⁵C=CR⁵-, -C=C-, Si(R⁵)₂, Ge(R⁵)₂, Sn(R⁵)₂, C=O, C=S, C=Se, C=NR⁵, -O-, -S-, -NR⁵- ou -CONR⁵- et où un ou plusieurs atome(s) de H peut/peuvent être remplacé(s) par F, CI, Br, I, CN, OH ou NO₂, ou un système de cycle aromatique ou hétéroaromatique ou un groupe aryloxy ou un groupe hétéroaryloxy, dans chaque cas comportant 2 à 40 atomes de C, où un ou plusieurs atome(s) de H peut/peuvent être remplacé(s) par F, CI, Br, I, CN, OH ou NO₂ ou lequel peut être substitué par un radical ou plusieurs radicaux R⁴, ou une combinaison de 2 à 5 de ces systèmes ; deux substituants R¹, R² et/ou R³ ou plus peuvent ici former un autre système de cycle aliphatique ou aromatique monocyclique ou polycyclique l'un avec l'autre ou les uns avec les autres ;
R⁴ est pour chaque occurrence, de manière identique ou différente, H, F, CI, Br, I, CN, OH, NO₂ un groupe alkyle, alcoxy ou thioalcoxy en chaîne droite, ramifié ou cyclique comportant 1 à 22 atome(s) de C, où, en outre, un ou plusieurs atome(s) de C non adjacent(s) peut/peuvent être remplacé(s) par -R⁵C=CR⁵⁻, -C≡C-, Si(R⁵)₂, Ge(R⁵)₂, Sn(R⁵)₂, -NR⁵-, -O-, -S-, -CO-O-, -O-CO-O-, où, en outre, un ou plusieurs atome(s) de H peut/peuvent être remplacé(s) par F, Cl, Br, I, CN, OH ou NO₂ un groupe aryle, hétéroaryle ou aryloxy comportant 1 à 40 atome(s) de C, lequel, en outre, peut être substitué par un radical ou plusieurs radicaux R⁵, ou OH, N(R⁵)₂, B(R⁵)₂ ou Si(R⁵)₃ ;
R⁵ est pour chaque occurrence, de manière identique ou différente, H ou un radical hydrocarbone aliphatique ou aromatique comportant 1 à 20 atome(s) de C,
n est pour chaque occurrence, de manière identique ou différente, 1, 2, 3 ou 4 ;
le lien en pointillés représente la liaison sur le polymère ;
**caractérisés en ce que** les unités de la formule (5) et/ou l'émetteur de triplet est/sont mélangé(s) dedans.

2. Mélanges BLEND1 selon la revendication 1, comprenant :
(A) 5 - 99,9% en poids d'au moins un polymère POLY1 contenant 1 - 100% (pourcentage molaire) d'une ou de plusieurs unité(s) récurrente(s) des formules (2) à (4) ; et
(B) 0,1 - 95% en poids d'un ou de plusieurs émetteur(s) de triplet (TRIP1).

3. Mélanges BLEND1 selon la revendication 2, **caractérisés en ce que** la proportion des unités structurelles des formules (2) à (4) dans le polymère POLY1 est dans la plage de 5 - 80% (pourcentage molaire).

4. Mélanges BLEND2 selon la revendication 1, comprenant :
(A) 0,5 - 99% en poids d'au moins un polymère POLY2 contenant 0,1 - 100% (pourcentage molaire) d'un ou de plusieurs émetteur(s) de triplet liés de manière covalente (TRIP2) ; et
(B) 1 - 99,5% en poids d'au moins un composé de la formule (5) qui dispose de la capacité de former des couches similaires à du verre à température ambiante.

5. Mélanges BLEND3 selon la revendication 1, comprenant:
(A) 0,5 - 98,5% en poids d'au moins un polymère POLY3 ;
(B) 1 - 99% en poids d'au moins un composé de la formule (5) qui dispose de la capacité de former des couches similaires à du verre à température ambiante ; et
(C) 0,1 - 95% en poids d'un ou de plusieurs émetteur(s) de triplet (TRIP1).

6. Mélanges BLEND2 ou BLEND3 selon la revendication 4 ou 5, **caractérisés en ce que** la proportion de composés de la formule (5) dans le blend est dans la plage de 5 - 80% en poids.

7. Mélanges selon une ou plusieurs des revendications 1 à 6, **caractérisés en ce que** les polymères POLY1 à POLY3 sont conjugués ou partiellement conjugués.

8. Mélanges selon une ou plusieurs des revendications 1 à 7, **caractérisés en ce que** les polymères POLY1, POLY2 et POLY3 contiennent d'autres éléments structurels en plus des unités des formules (2) à (4) (dans POLY1) et de l'émetteur de triplet TRIP2 (dans POLY2).

9. Mélanges selon la revendication 8, **caractérisés en ce que** les autres unités structurelles forment le squelette de polymère ou améliorent les propriétés d'injection de charges et/ou de transport de charges.

10. Mélanges selon une ou plusieurs des revendications 1 à 9, **caractérisés en ce que** A représente, de manière identique ou différente pour chaque occurrence, Si ou Ge.

11. Mélanges selon une ou plusieurs des revendications 1 à 10, **caractérisés en ce que** Y représente, de manière identique ou différente pour chaque occurrence, un système de cycle aromatique comportant 2 à 40 atomes de C, lequel peut être substitué par un radical ou plusieurs radicaux R⁴, ou un groupe stilbène ou tolane qui est substitué par R⁴ ou qui est non substitué.

12. Mélanges selon une ou plusieurs des revendications 1 à 11, **caractérisés en ce qu'**au moins l'un des substituants R¹ à R³ représente un système de cycle aromatique ou hétéroaromatique comportant 2 à 40 atomes de C, lequel peut être substitué par un ou plusieurs substituant(s) R⁴.

13. Mélanges selon une ou plusieurs des revendications 1 à 12, **caractérisés en ce que** l'indice n est, de manière identique ou différente pour chaque occurrence, 1, 2 ou 3.

14. Mélanges selon une ou plusieurs des revendications 1 à 13, **caractérisés en ce que** les unités des formules (2) à (5) présentent une structure symétrique.

15. Mélanges selon une ou plusieurs des revendications 1 à 14, **caractérisés en ce que** les unités des formules (2) à (5) sont choisies parmi les Exemples (1) à (48) qui suivent :
| | | |
|---|---|---|
| 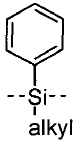 | 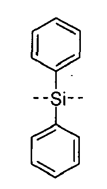 | 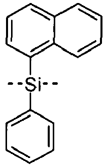 |
| Exemple 1 | Exemple 2 | Exemple 3 |
| 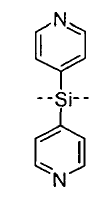 | 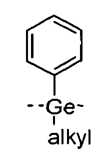 | 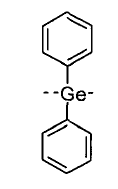 |
| Exemple 4 | Exemple 5 | Exemple 6 |
| 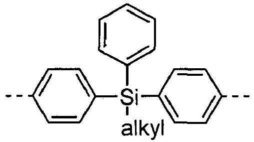 | 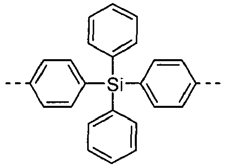 | 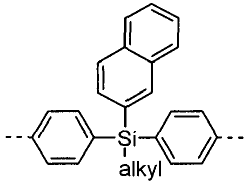 |
| Exemple 7 | Exemple 8 | Exemple 9 |
| 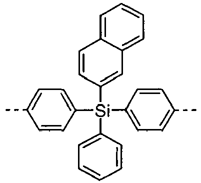 | 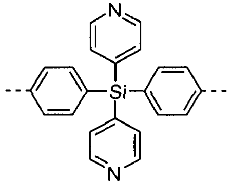 | 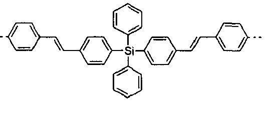 |
| Exemple 10 | Exemple 11 | Exemple 12 |
| 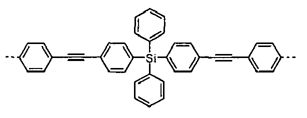 | 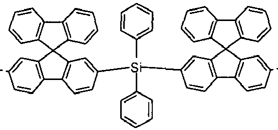 | 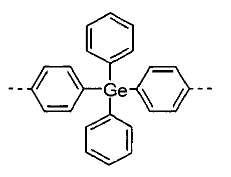 |
| Exemple 13 | Exemple 14 | Exemple 15 |
| 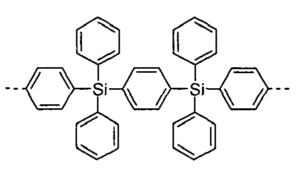 | 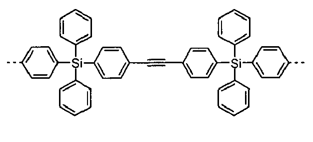 | 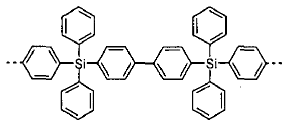 |
| Exemple 16 | Exemple 17 | Exemple 18 |
| 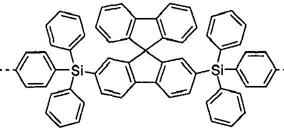 | 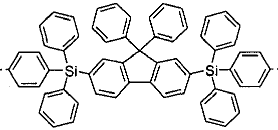 | 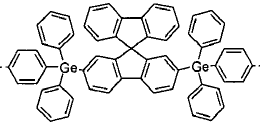 |
| Exemple 19 | Exemple 20 | Exemple 21 |
| 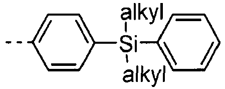 | 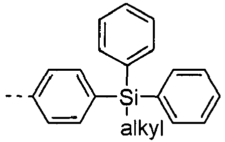 | 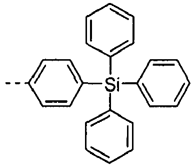 |
| Exemple 22 | Exemple 23 | Exemple 24 |
| 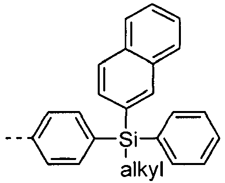 | 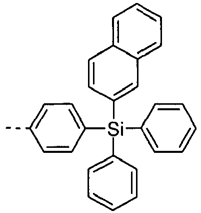 | 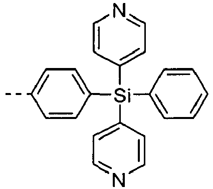 |
| Exemple 25 | Exemple 26 | Exemple 27 |
| 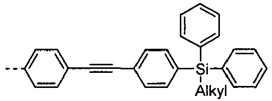 | 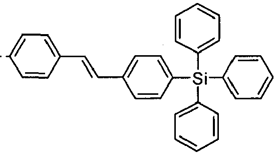 | 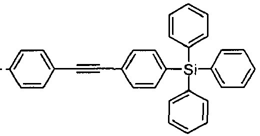 |
| Exemple 28 | Exemple 29 | Exemple 30 |
| 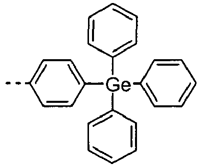 | 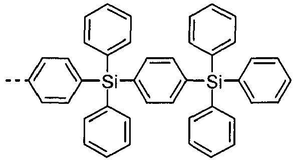 | 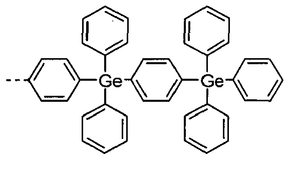 |
| Exemple 31 | Exemple 32 | Exemple 33 |
| 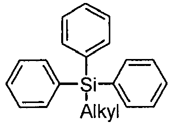 | 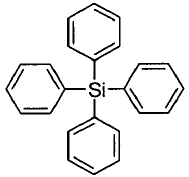 | 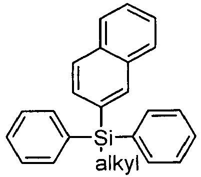 |
| Exemple 34 | Exemple 35 | Exemple 36 |
| 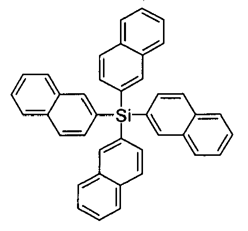 | 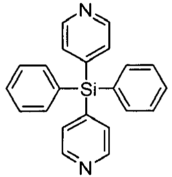 | 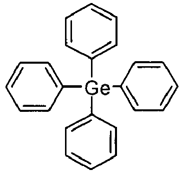 |
| Exemple 37 | Exemple 38 | Exemple 39 |
| 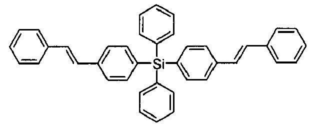 | 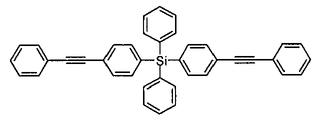 | 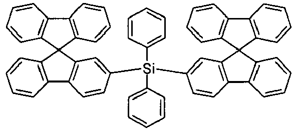 |
| Exemple 40 | Exemple 41 | Exemple 42 |
| 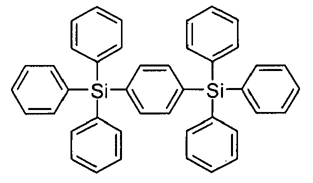 | 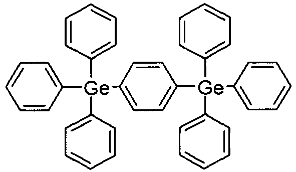 | 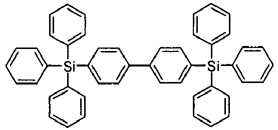 |
| Exemple 43 | Exemple 44 | Exemple 45 |
| 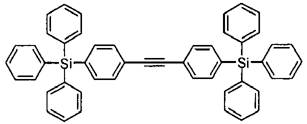 | 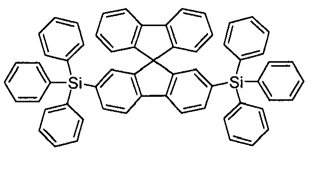 | 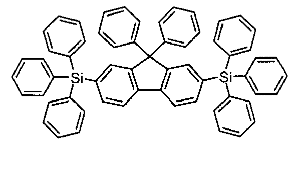 |
| Exemple 46 | Exemple 47 | Exemple 48 |

16. Mélanges selon une ou plusieurs des revendications 1 à 15, **caractérisés en ce que** les composés de la formule (5) sont mélangés à l'intérieur de BLEND1.

17. Mélanges selon une ou plusieurs des revendications 1 à 16, **caractérisés en ce que** les émetteurs de triplet contiennent au moins un atome du Tableau Périodique des Eléments présentant un numéro atomique supérieur à 36.

18. Mélanges selon la revendication 17, **caractérisés en ce que** les émetteurs de triplet contiennent des métaux de transition d et/ou f.

19. Mélanges selon la revendication 18, **caractérisés en ce que** les émetteurs de triplet contiennent au moins un élément pris parmi les groupes 8 à 10.

20. Mélanges selon une ou plusieurs des revendications 1 à 19, **caractérisés en ce que** d'autres polymères, oligomères, dendrimères conjugués, partiellement conjugués ou non conjugués et/ou d'autres composés de poids moléculaire faible sont mélangés à l'intérieur de BLEND1 à BLEND3.

21. Utilisation d'un mélange selon une ou plusieurs des revendications 1 à 20 dans un dispositif électronique organique.

22. Dispositif électronique organique comportant une ou plusieurs couche(s), où au moins l'une de ces couches comprend au moins un mélange selon une ou plusieurs des revendications 1 à 20.

23. Dispositif électronique organique selon la revendication 22, **caractérisé en ce qu'**il s'agit d'une diode émettrice de lumière organique (PLED), d'une cellule solaire organique (O-SC), d'un dispositif optique non linéaire, d'un dispositif pour le doublage de fréquence, d'un détecteur optique organique, d'un dispositif à extinction de champ organique ou d'une diode laser organique (O-laser).
